(19)

Europäisches
Patentamt
European
Patent Office
Office européen
des brevets

(11) **EP 4 353 700 A1**

(12) **EUROPEAN PATENT APPLICATION**
published in accordance with Art. 153(4) EPC

(43) Date of publication:
**17.04.2024 Bulletin 2024/16**

(21) Application number: **22820651.2**

(22) Date of filing: **28.04.2022**

(51) International Patent Classification (IPC):
**C04B 35/626** $^{(2006.01)}$      **C04B 35/634** $^{(2006.01)}$
**C04B 35/45** $^{(2006.01)}$      **C04B 35/462** $^{(2006.01)}$
**C04B 35/49** $^{(2006.01)}$

(86) International application number:
**PCT/RU2022/050141**

(87) International publication number:
**WO 2022/260557 (15.12.2022 Gazette 2022/50)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **10.06.2021 RU 2021116854**

(71) Applicant: **Epshtein, Oleg Iliich**
**Moscow 127473 (RU)**

(72) Inventors:
• **TARASOV, Sergey Aleksandrovich**
  **VNIISSOK village, 143080 (RU)**
• **BUSH, Aleksandr Andreevich**
  **Moscow, 111625 (RU)**
• **HARCHEVSKY, Anton Alexandrovich**
  **Zagoryansky village, 141181 (RU)**
• **EPSHTEIN, Oleg Iliich**
  **Moscow, 127473 (RU)**

(74) Representative: **Lam, Oliver**
**Kilburn & Strode LLP**
**Lacon London**
**84 Theobalds Road**
**London WC1X 8NL (GB)**

(54) **MODIFYING AGENT AND METHOD OF ALTERING THE ELECTROPHYSICAL AND MAGNETIC PROPERTIES OF A CERAMIC**

(57) The invention lies within the field of ceramic technology, in particular ceramic production technology. Namely, it refers to modifier that alters the electrophysical and magnetic properties of ceramics, which is a product of technological processing of one or more batch mix components of the specified ceramic sample, the relevant ceramic sample, an intermediate product obtained after baking of the relevant ceramic sample, a known alloying agent, or a combination thereof. It also refers to the method for altering the electrical and magnetic properties of ceramics, according to which the dry batch mix is saturated with the claimed modifier, followed by baking and sintering according to the relevant ceramic sample production technology. The invention provides for the production of modified ceramics with improved electrical and magnetic properties, without the formation of impurity defects in the crystalline structure of the resulting ceramics.

**EP 4 353 700 A1**

**Description**

The present invention lies within the field of ceramic processing technology, in particular ceramics production technology. Namely, it refers to a modifier that alters the electrical and magnetic properties of ceramics, and to a method for such alteration of the electrical and magnetic properties of ceramics.

Ceramics are polycrystalline inorganic materials; ceramics are also the goods made of these materials employing ceramic processing technology which includes the following mandatory stages: powder grinding (homogenization), molding powders into products (pressing), baking and sintering [A.A. Polyakov, Technology of ceramic radio-electronic materials. Moscow: Radio I Svyaz, 1989, page 200]. According to the levels of their electrical conductivity, ceramic materials are divided into dielectrics, semiconductors, conductors and superconductors. The differences between them are determined by the nature of the chemical bond and the structure of the energy bands arising from the interaction of atoms or ions that make up the crystal lattice.

**High-temperature superconducting ceramics (HTSC ceramics)** is a product based on oxidic high-temperature superconductors whose transition into superconducting state requires high critical values of $T_c$ temperatures (>77 K). This class of substances is characterized by the presence of strong electron correlations that determine their physical properties and the latter's strong dependence on the (micro)structural factor. Ceramic superconductors are very promising, mainly because they can be studied and used when cooled with liquid nitrogen which is relatively inexpensive.

To date, the main challenge in HTSC engineering is to further boost their critical temperature, that is, to create substances whose $T_c$ would fit into the range of room temperatures [Barash Yu.S., HIGH-TEMPERATURE SUPERCONDUCTORS // The Great Russian Encyclopedia, Volume 6. Moscow, 2006, pp. 140-141]. By 2020, the highest-temperature superconductors at atmospheric pressure are cuprate ceramics (mixed oxides).

Ceramic HTSCs are used, for instance, as current leads and electromagnet protection devices, as elements of magnetic shields and magnetic suspensions without friction of moving parts, etc.

Among dielectrics with special properties, **piezoelectric and ferroelectric materials** should be singled out. In many crystals, when stretched and compressed in certain directions, electric polarization occurs. As a result, their surfaces yield electric charges of both types. This phenomenon is called the direct piezoelectric effect. The reverse piezoelectric effect is the effect when a piezoelectric crystal gets deformed when introduced into an electric field, under the impact of the mechanical stresses thus evoked. [Salakhov A.M. Modern materials; Ministry for Education and Science of the Russian Federation, KFU. Kazan: Kazan Federal University, 2016, p. 349]. Ceramics based on ferroelectric materials is called ferroelectric ceramics. Similarly, piezoelectric ceramics is ceramics obtained on the basis of piezoelectric materials.

By changing the ratios of the initial elements and introducing various additives, piezoelectric compositions can be synthesized that have specified electrophysical and piezoelectric properties.

Increase of the scope of application of piezoelectric ceramics leads to an increase in requirements for its performance characteristics; there arises a need in new manufacturing technologies allowing for a wider variation of dielectric and electromechanical characteristics. The most important areas of technology development include the creation of piezoceramics capable of functioning at high temperatures (T>700°C) [Spitsin A.I., Bush A. A., Kamentsev K.E. Piezoelectric and dielectric properties of Bi3TiNbO9 prepared by hot pressing from powders activated using the serial dilution method. Sci Rep 10, 22198 (2020)].

The possibility to obtain and use high-temperature piezoelectric ceramics is hampered by its inherent high porosity (10 to 25%). This disadvantage is due to poor sintering compactibility of flake-like crystallites specific to ferroelectric materials with high $T_c$, for example, such as ferroelectric Bi-containing compounds $[Bi_2O_2]$ $[_{An-1}B_nO_{3n+1}]$ with a layered perovskite-like structure (Bi-based layer structure ferroelectric, BLSF). The issue of obtaining high-performance piezoceramic BLSF samples is also aggravated by their relatively high conductivity and their depolarization at T>870 K. The samples of bismuth niobate titanate $Bi_3TiNbO_9$ (BTN) which belongs to the BLSF family, obtained by conventional ceramic technology, are characterized by their low $d_{33}$ values ($\sim \leq 7$ pC/N), which is explained by their increased porosity, as well as the lack of microstructural crystallinity of such ceramics [Zhang Z, Yan H, Dong X, Wang Y. Preparation and electrical properties of bismuth layer-structured ceramic Bi3TiNbO9 solid solution. Materials Research Bulletin. 2003. V.38. No.2. P.241-248.].

Therefore, the top priority task is to develop the efficient technologies that make it possible to enhance the electrophysical and magnetic properties of high-density effective piezoelectric ceramics, and to assess how the production environment impacts the structure, microstructure, mechanical and functional properties of the material. It should be remembered that the microstructure of ceramics (the linear dimensions of its grains and pores, their shape, volume fraction and method of connectivity in the system) directly impacts the dielectric and mechanical properties of the system as a whole, and, consequently, the values of the electrophysical parameters of the samples [Nesterov A.A., Panich A.A. Actual problems of materials science of ceramic piezomaterials, 2010.].

It is known from the prior art that the use of modifying additives (alloying agents), in addition to increasing the mechanical, thermal and electrical properties, can lead to the formation of extra phases with their own characteristics, which will be substantially modified at high temperatures [Zhitnyuk S.V., The influence of sintering additives on the properties of ceramics based on silicon carbide, 2019].

For instance, when silver is used for additive during the manufacturing of HTSC ceramics, oxygen diffusion improves and superconductivity is maintained; besides, silver reduces the resistance of HTSC materials in their normal condition and decreases their contact resistance, and a decrease in the effect of uniaxial compression on the current-voltage characteristics of silver-doped samples is observed. [Influence of silver content on mechanical and electrical properties of HTSC ceramics YBaCuO/Ag. Markov L.K., Solid State Physics, 2003].

At the same time, silver ions can also be found inside YBCO grains. In addition to excellent chemical compatibility with YBCO, substituted Ag induces small changes in lattice parameters "a" and "b". However, since copper and silver belong to the same group of the periodic table, Ag atoms can replace Cu(1) in YBCO; therefore, the presence of microscopic granularity can affect many physical properties [Conductivity Fluctuations of Polycrystalline Ag-Doped $YBa2Cu3O7$-$\delta$ Superconductor, Paula de Axambuja, 2010].

A method of manufacturing Y-Ba-Cu-O system phases by crucible-free zonal melting is known in the art [RU 2062308 C1, Bush A.A. et al., 20.06.1999]. The purpose of the invention is to increase the degree of texturing and to obtain single-phase samples. To achieve this goal, it is suggested that a Bi-containing reagent, for example, $Bi_2O_3$, should be added, in a certain proportion, to the initial mixture consisting of Y-, Ba- and Cu-containing reagents.

A high-temperature superconductor based on lithium compound $Si_1$-$xCxLi_4$, where $0 \leq x \leq 0.02$ [RU 2351677 C2, Donchak A.A., 10.04.2009], is known in the art. The use of a lithium compound for superconductor can make it possible to increase the critical temperature of the superconducting transition. However, such HTSCs are not industrial materials and their $T_c$ is low.

The use of sodium dititanate as an initiator of solid-phase reactions for the synthesis of piezoceramics of lead zirconate-titanate is known in the art [RU 2018499 C1, Popov G.P. et al., 08.09.1991].

There is a method of production of a microporous composite piezomaterial with a porosity higher than 15% and pore size of 1-3 microns with an increase in the values of the longitudinal piezoelectric modulus $d_{33}$ and the electromechanical coupling coefficient with the thickness of the vibration mode $k_t$ of the original piezoceramic material and a decrease in the coefficient of electromechanical coupling of the planar vibration mode $k_p$, the transverse piezoelectric modulus $d_{31}$ and mechanical quality factor $Q_M$. The method includes mixing powdered piezoceramic material with powdered bloating agent weight to weight, to obtain a porous ceramic matrix with closed pores. It also involves adding polyvinyl plasticizer, pressing and baking a workpiece according to the invention. For bloating agent, crystalline lithium niobate ($LiNbO_3$) powder is used, with an average particle size D close to the ultrasonic wavelength $\lambda$ ($0.1\lambda < D < \lambda$) in a piezoelectric element, in an amount of 5 to 15 vol. % [RU2713835 C1, Lugavaya M.A. et al., 22.05.2019].

Piezoelectric ceramic material is known. It contains PbO, $Nb_2O_5$, $TiO_2$, and also contains MgO, NiO and ZnO at the specified ratio of components, wt. %, which leads to the formation of oxygen vacancies during sintering and to the formation of a ferro-soft structure, increasing the mobility of domain walls and, as a consequence, increasing the dielectric constant, the piezoelectric modulus $d_{33}$, and other indicators. [RU 2498958 C1, Federal State-Funded Educational Institution for Higher Vocational Education "Southern Federal University", 08.06.2012].

All the known methods of producing ceramics with improved properties, including the introduction of additional modifying/alloying agents, in addition to their beneficial effect, lead to the formation of inhomogeneities and crystallization centers, and to lower uniformity of the final product with critical defects, as well as to impurities of the lattice structure.

Due to the fact that the crystalline lattices of all superconductors have a center of symmetry, the higher the symmetry of the crystal lattice, the more likely superconductivity is. The dependence of superconductivity on the crystal structure is due to the fact that the electronic structure of atoms and their spatial arrangement (crystal structure) depends on the electron density and electronic energy spectrum of the metal, alloy or compound [https://studopedia.su/12_66326_lektsiya--sverhprovodimost-fizicheskie-osnovi-proyavleniya-sverhprovodimosti-sverhprovodyashchie-materiali.html]. The effective charges of atoms, their electronic structure and the spatial distribution of electronic imperfections (electrons and holes) in crystalline lattices determine the phenomenon of high-temperature superconductivity of copper metal oxides of the $YBa_2Cu_3O_7$ type. Thus, critical current density $J_c$, which is the main characteristic of a superconducting material, characterizes the maximum electric current that can flow through a conductor without resistance. The actual $J_c$ values are significantly lower than the theoretical possible limit. This is due to the fact that $J_c$ is a structure sensitive quantity influenced by such parameters as crystallographic parameters of grain boundaries, lattice defects, particles of secondary phases and grain size [Kabirova D.B. Evolution of microstructure and texture upon annealing and deformation of superconducting ceramics $YBa_2Cu_3O_7$-x. Thesis paper for the degree of candidate of physico-mathematical sciences, 01.04.07, Federal Budget-Funded Scientific Institution "Institute for Metals Superplasticity Problems" of the Russian Academy of Sciences, Ufa, 2020].

Of piezoelectric substances, piezoelectric modulus $d_{33}$ is the one most widely applied in practice. Its index means that it describes normal deformations parallel to the polarization axis arising under the influence of an external field parallel to this axis, or the charges emerging on a surface normal to the polarization axis under mechanical loadings parallel to this axis. The direction of the external electrical or mechanical stimulus relative to the crystallographic axes of the elementary lattice plays a huge role in the processes of the direct and inverse piezoelectric effect.

When one of the atoms in the crystalline lattice can be replaced by an impurity atom, it leads to formation of an impurity defect in the crystal structure, called impurity substitution atom. An impurity atom can also be located in an interstitial site, as if embedded into it. Such a defect is called impurity interstitial atom; it often emerges when the impurity atom is much smaller than the crystal atoms and there are interstices of sufficient size in the crystalline lattice. If the impurity atom is larger than the crystal atoms, then, as a rule, it will replace the crystal atoms. The presence of impurity atoms leads to crystalline lattice defects and to alteration of the ceramic properties [Vintaykin B.E. Solid state physics. Moscow: Publishing house of the Bauman Technical University, 2006].

It is known from the prior art that steady-state water is an open nonequilibrium system capable of depositing extra free energy, and that external influences (optical, plasma, mechanical, etc.) are capable of drastically changing the macroscopic properties of liquid solutions [Bruskov V.I. et al., 2020; Shcherbakov I.A., 2020a; Shcherbakov I.A., 2021; Baymler I.V. et al., 2020; Mai-Prochnow A. et al, 2021; Zhao Y.M. et al., 2020]. A particular case of the formation of such systems is a combination of external influence and sequential multiple dilution of the initial substance leading to obtaining of the release-active (RA) substance forms. The dilutions obtained in the course of this process acquire peculiar long-lasting physicochemical and biological properties that differ both from the properties of the original substance and from the properties of the original solvent (water) [Gudkov S.V. et al., 2020a; Gudkov S.V. et al., 2020b; Ryzhkina I.S. et al., 2015].

Previously, the products of multiple dilution technology known since the 18th century in combination with external exposure, were termed as "potentiated drugs" [RU2183325, RU2565401, RU2579262], indicating their dilution degree and dilution scale: for example, multiple dilution of 10 (D dilution) or 100 (C dilution) times.

It is known from the prior art [RU2643934, RU2643936] that the present-day generally accepted analytical methods, ELISA and spectrometry, make it possible to directly determine the intensity of the modifying activity associated with the carrier, acquired during the processing treatment of the carrier with the initial substance in the form of a multiple sequential deconcentration of the latter using the carrier.

The technical objective of the present invention is to obtain a modifier capable of changing the electrical and magnetic properties of ceramic samples, in particular HTSC and piezoelectrics, and, at the same time, making it possible to avoid formation of impurity defects in the crystalline structure.

The task may be solved by obtaining a modifier, which is a technology-processed product (the final product of the processing treatment) of one or several batch constituents of the specified ceramic sample (ceramics), ceramic sample, intermediate product, alloying agent or their combination in liquid form, for which the term "release-active (RA) form" ("release-active (RA) dilution") is used. In addition, the present invention discloses a method of alteration of the electrophysical and magnetic properties of ceramics, according that the dry mixture of the batch is saturated with modifier, which is obtained by sequential grinding with further multiple sequential dilution and external, mainly mechanical impact ("RA dilution") of one or several components of the batch / alloying agent / ceramic sample, followed by baking and sintering according to the relevant ceramics production technology.

The technical result of the claimed invention consists in obtaining, by method of solid-phase reactions, of modified ceramics with improved electrophysical and magnetic properties (increasing the Meissner effect, increasing the temperature of the superconducting transition, increasing the critical current density $j_e$, increasing the piezoelectric constant of the substance, increasing the pyroelectric constant), avoiding the formation of impurity defects in the crystalline structure of the resulting ceramics, that is, impurity atoms.

The term "modifier" means an additive that acts as an alloying agent, which is release-active (RA) dilution of one or more components of the batch mix used to produce ceramics, and/or release-active form of the corresponding ceramic sample or intermediate product produced after the baking stage upon the obtainment of the specified ceramic sample and/or release-active form of a known alloying agent. In this case, the modifier additive can be introduced into the dry mixture of the initial components (batch mix) used to produce a ceramic sample, before the baking stage; also, the modifier can be added to the samples obtained after baking, before the sintering stage; also the modifier can be added to the finished ceramic sample (ground after the sintering stage). Besides, the modifier additive can be added both once and several times at different stages of ceramic production. As an embodiment of the invention, the production of a single ceramic sample can require modifiers of different compositions at various stages of production.

The term "batch mix" is understood to be a mixture of initial components in a certain proportion to be processed in metallurgical, chemical and other units in order to obtain a given item of ceramics. The batch mix is designed to obtain final products with specified physical and chemical properties; it includes initial components and, if necessary, alloying agents and other additives.

At the same time dry powdered mixture of the initial components (the batch mix) of ceramics, or dry powdered mixture of a finished ceramic sample or an intermediate product obtained after baking (for instance, the $Bi_3TiNbO_9$ phase powder) can be saturated with a relevant modifier. The term "saturation" means complete moistening of the modified sample with the claimed modifier. The procurement of moistened powders will require measurement of the volume of the alcohol solution required to moisten a given amount of powder (so that each particle of the powder is completely moistened via stirring). Moisture adequacy is assessed visually. The technologically effective balance of the dry mixture and the modifier required moistening, and, consequently, the amount of the modifier required in each specific case, is determined empirically based on the amount of the substance to be modified. If necessary, the end product may be controlled by X-ray method.

The term "ceramic sample" is understood to mean ceramic material, that is, ceramics obtained via solid-phase reactions, for example, high-temperature superconducting ceramics (HTSC), piezoelectric ceramics (piezoelectrics), etc.

As initial components for obtaining superconducting ceramics, oxides and carbonates of various compositions can be used in the form of dry powders, along with their peroxides, hydroxides or salts, as well as alloying agents used according to established manufacturing prectices. HTSC ceramics contain rare earth elements Y, La, Nd, Sm, Eu, Cd, Ho, Er, Tm, Lu. For instance, for yttrium ceramics $YBa_2Cu_3O_7$-d with $T_c$ = 91K may require a mixture of powdered compounds $Y_2O_3$, $BaCO_3$, $CuO$, or, for example, a mixture of powders $Y_2O_3$, $BaO_2$, $CuO$; bismuth ceramics is based on $Bi_2Sr_2Ca_2Cu_3O_y$ and $Bi_2Sr_2CaCu_2O_y$ with $T_c$ = 115K.

As initial components for obtaining piezoelectric ceramics, titanium, zirconium and lead oxides may be used, as well as piezoceramic materials based on bismuth titanate and barium titanate in the form of dry powders of metal oxides, used according to the known industrial methods. Most piezoceramic compositions are based on chemical compounds with perovskite-type crystal structure with the $ABO_3$ formula (for instance, $BaTiO_3$, $PbTiO_3$) and various solid solutions based on them (for instance, $BaTiO_3$ - $CaTiO_3$; $BaTiO_3$ - $CaTiO_3$ - $CoCO_3$ systems). Also, to produce high-temperature piezoelectric materials, ferroelectrics with high $T_c$ are used, such as: BLSF with Tc>900°C and bismuth niobate titanate $Bi_3TiNbO_9$ (BTN) which has the highest Curie point $T_c$ among the BLSF family, 1213K. For example, in the production of $Bi_3TiNbO_9$-based piezoelectric ceramics with the structure of layered pervoxite, a mixture of powdered oxides $Bi_2O_3$, $TiO_2$ and $Nb_2O_5$ with molar ratio of 3:2:1 can be used.

The term "alloying agent" refers to additives used to endow the end product with certain chemical, physical or mechanical properties. Alternatively, an additional alloying component may be added at the stage of preparation of the powdered dry mixture of the initial components (batch mix). Thus, superconducting ceramics will require such alloying agents as Ag, Ca, Pt, Zr, K, Cl, Al, Ce, $AgNO_3$, CaO and others. Piezoelectric ceramics will require such alloying agents as $BaZrO_3$, $CaTiO_3$, $La_2O_3$, NbzOs, TazOs, $MnO_2$, $Fe_2O_3$, $Cr_2O_3$, $Bi_2O_3$, NiO and $WO_3$.

The term "modification" is understood as alteration of the piezoelectric and superconducting functional properties of ceramic samples, in particular, the electrophysical and magnetic properties of ceramics.

"Functional properties" are understood as the properties that characterize the main purpose of a substance, and as the ability of substances to perform their main functions.

"Electrophysical properties" are understood as the properties displayed by substances when exposed to an electric field and the flow of an electric current.

"Magnetic properties" are understood as the properties displayed by substances when exposed to a magnetic field.

Piezoelectric properties are:

*Piezoelectric modulus (piezomodulus) $d_{ij}$* is the induced polarization in the "i" direction per unit of mechanical pressure applied in the "j" direction, or the amount of deformation in the "i" direction per unit of electric field applied in the "j" direction;

*Pyroelectric constant $p^{(X)}$* is the ratio of the change in the polarization of the dielectric to the temperature range that caused such change.

Superconducting properties are:

*SC transition temperature* is the temperature characterizing the reversible transition of the superconductor from the normal state to the superconducting state and equal to the temperature which, with a given magnetic induction, reduces the resistance of the superconductor to half of its normal resistance;

*Magnetic susceptibility □ '(□)* is a value characterizing the tendency of substances to magnetize in a magnetic field, scalar for isotropic substances and tensor for anisotropic substances. When multiplied by the magnetic field strength value, it yields the magnetization value.

*Critical current density ($j_e$ and $j_i$)* is the current density causing the emersion of an electric field or specific electrical resistance of a given value in a superconductor, provided that the current is uniformly distributed over the cross section of the superconductor.

*Release activity* refers to the activity that appears as a result of "high dilutions" of the parent substance. The release-active dilution of a substance is an aqueous or aqueous-alcoholic solution, whose activity is associated with the process of multiple serial dilutions of the original matrix solution the active ingredient, in an aqueous or aqueous-alcoholic solvent in combination with external mechanical action (for instance, shaking of each dilution) [O.I. Epstein. Ultra-low doses (A history of one study). Moscow: RAMS Publishing House, 2008, p.336; Epstein O. The spatial homeostasis hypothesis // Symmetry. - 2018. - Vol.10 (4)]. Release-active dilution acquires special properties in the course of repeated exposure to an intact carrier of the parent substance or its solutions, including highly diluted ones, in combination with external exposure.

The term "release activity" (RA) denotes a set of new properties that become manifest in a neutral carrier during its processing in the presence of the parent substance (treated carrier). Processing treatment is a multiple transfer of a portion of the treated carrier into a neutral carrier in combination with an external effect on the resulting composite. External influence can be both mechanical (including the methods of acoustics and microfluidics) and electromagnetic. The principal feature of the release-active forms of substances is their ability to specifically affect the parent substance modifying its physicochemical properties.

The term "release-active form" is used to denote the end product with special properties, including modifying properties, obtained by multiple serial dilutions of the parent substance in combination with external processing of each dilution, in particular, mechanical shaking (potentiation). The technology for production of a release-active dilution is production of an activated-potentiated form of a substance and can also be called "activation-potentiation process"

[WO2012017324, US No. 7,229,648 and 4,311,897]. External treatment as part of the process of reducing the concentration can also be achieved, for instance, by exposure to ultrasonic, electromagnetic or other physical factors. [Schwabe V., Homeopathic Medicines, Moscow, 1967, US Patents Nos. 7,229,648 and 4,311,889; Epshtein O.I. Release-activity (a modern view of homeopathy and non-homeopathy), Moscow: Publishing house of the Russian Academy of Medical Sciences, 2017].

The above procedure leads to the formation of special properties in the release-active dilutions that do not depend on the concentration of the original substance retained in them. This procedure is repeated until the required dilution is obtained, which has a certain degree of modifying effect, which can be assessed using ELISA and other methods [RU2643934, RU 2643936].

Historically, following the homeopathic tradition, the degree of dilution of the release-active form is denoted by a Latin letter (for example, D for decimal dilutions, C for centesimal dilutions, etc.), and a number indicating the number of repetitions of the dilution. [Schwabe V., Homeopathic medicines, Moscow, 1967, US patents Nos. 7,229,648 and 4,311,889].

The term "release-active form of a substance" should be understood as any dilutions, including decimal, hundredth, thousandth aqueous or aqueous-alcoholic dilutions of the matrix solution of the parent substance, starting from C2 (i.e., dilution of the matrix solution by a factor of $100^2$), and also any combinations of them (for example, C2 + D34 + M45, D20 + C4, etc.) and ratios (for instance, 1:1:2, 2:3, etc.).

The release-active form of the active substance is obtained by way of uniform reduction of the concentration by way of successive dilution of 1 unit of the said matrix solution in 9 units (for decimal dilution D), or in 99 units (for centesimal dilution C), or in 999 units (for thousandth dilution M) of aqueous or aqueous-alcoholic solvent in combination with external impact (e.g. shaking) on each resulting dilution, using separate containers for each subsequent dilution.

For instance, to prepare a 12-fold centesimal dilution (denoted as C12) of substance A, one unit of the stock solution of substance A is diluted in 99 units of a neutral aqueous or aqueous-alcoholic solvent (neutral carrier), and then shaken vertically several times (10 or more) to obtain the 1st dilution (denoted as C1). The second dilution (C2) is obtained in a similar manner from the first dilution C1. This procedure is repeated 11 times to obtain C12 dilution. Thus, C12 dilution is a solution obtained by 12 successive dilutions of one unit of the initial matrix solution of substance A in 99 units of a neutral solvent in separate containers, which is equivalent to C12 dilution. Similar procedures with the appropriate dilution factor are followed to obtain dilutions C30, C50, C200 etc. Intermediate dilutions can be tested in the desired model to assess the effectiveness of each specific dilution.

Also, to obtain release-active dilutions (release-active forms), trituration can be used, that is, preparation by grinding one unit of the parent substance A with several units of a neutral carrier whose amount will depend on the desired degree of dilution (D, C, M, etc.). Large volumes may require mixers for trituration; the type of mixer and its operation pattern can be determined experimentally and specified in the standard operating procedures.

For instance, to obtain triturations manually up to the fourth decimal (D4) or fourth centesimal (C4) dilution, inclusive, the following procedure should be followed. The required amount of neutral carrier is divided into three equal portions. The first portion is placed in a mortar and ground to close the pores of the mortar. Then the entire amount of the active component is added and ground with effort, after which the powder is raked with a spatula and scraped off the walls of the mortar; this operation is repeated once more. Then the second and the third portions of the neutral carrier are added sequentially. The operations described above are repeated for each portion. Any subsequent dilutions will require similar course of operations.

When using the mechanical method for the production/manufacture of triturations from powders up to the fourth decimal (D4) or fourth centesimal (C4) dilution, inclusive, the active components and excipients are added and ground, following the sequence similar to that required for the mortar procedure.

Dilutions beyond the fifth decimal (D5) or fifth centesimal (C5) will require procedures differing from the above-described method. Dilutions are obtained from 1 g of trituration of the previous decimal or centesimal dilution, mixed with 9 g or 99 g of a neutral carrier, previously divided into three equal portions. The entire amount of trituration of the previous dilution is gradually, in small portions, added to the first part of the neutral carrier, and ground thoroughly until a homogeneous powder is obtained. Then the second and third portions of the neutral carrier are added successively and thoroughly ground until smooth.

Manufacturing / production (manual or mechanical) of triturations will require the following processing of tinctures, solutions or liquid dilutions. The entire required amount of the neutral carrier is gradually, in small portions, diluted with the entire amount of the tincture, solution or previous liquid dilution and mixed thoroughly until smooth. The homogeneous wet mixture is then carefully dried, and if necessary crushed and mixed again. The procedure will require such amount of neutral carrier that would yield the required trituration mass after completion of the preparation.

Tinctures, matrix solutions and liquid dilutions used to obtain triturations should be potentiated in proportions relevant to their methods of preparation. Those will require the amount of neutral carrier that would yield the total mass of trituration after drying equal to 10 units for a decimal dilution and 100 units for a centesimal dilution.

Subsequent dilutions of triturations from tinctures, solutions or liquid dilutions are obtained from 1 unit of the trituration of the previous dilution and 9 units (for decimal scale) or 99 units (for centesimal scale) of the neutral carrier, mixing thoroughly until smooth.

The main elements that characterize ceramics manufacturing technology include homogenization, baking, product molding (pressing), and sintering.

In the present invention, ceramic samples are obtained via solid phase reactions. In this method, the synthesis is carried out from a mechanical mixture of finely ground solid particles; during solid-phase reactions, the formation of a substance is determined by the rate of ion diffusion. This technologically simple method makes it possible to preserve the exact chemical composition of the synthesized complex compositions required for the batch mix. It yields no harmful wastes, and it is notable for relatively low cost of the raw materials required.

Mixing and grinding the batch mix component powders (homogenization) is one of the main production operations. Homogenization is carried out at the initial stage, before baking. Homogenization baking leads to solid-phase reactions of interaction between the ceramic-forming components. The course of solid-phase reactions is determined by thermodynamic (decrease in free energy as a result of the reaction) and kinematic (determining the rate of reactions) factors. Solids, as a rule, do not interact with each other at ordinary temperatures. For them to inter-react at appreciable rates, heating to 1000°-1500°C might often be required. High temperatures are required for the ions to acquire energy sufficient to break the existing bonds, leave their normal position and begin to diffuse through the crystal. As a rule, the product of such homogenizing baking will not be sufficiently homogeneous, so therefore, after baking and before molding, it will require re-stirring and grinding to a given fineness.

Geometric shaping of ceramic samples is usually carried out by molding, i.e. extrusion into special shapes with the configuration of finished products. In order for the mass to uniformly fill the mold after grinding the powders, auxiliary substances are added, i.e. plasticizers, which do not change the plastic characteristics of the material particles themselves, but increase the plasticity of their conglomerate by reducing the friction of the particles against each other. Usually, solutions of organic polymers are used as plasticizers, for example, 5-10% aqueous solution of polyvinyl alcohol (PVA), castor oil, wood resin, paraffin, 30% solution of sulfite waste liquor (SWL). The plasticizer should be removed from the end product, since its rapid evaporation, decomposition or burnout in most cases will lead to the destruction of the finished products. Plasticizers are removed naturally in the open air, or in special dryers at temperatures of 300-500°C.

Sintering is the final stage in ceramics production, during which the porous powder-like workpieces are compacted and hardened under the influence of heat treatment. Sintering is accompanied by an increase in density and shrinkage, a decrease in porosity, and with alteration of the mechanical and physicochemical characteristics of the substance. The optimum sintering temperature is defined as the maximum temperature at which the rates of side processes (dissociation, evaporation, collective recrystallization, swelling, etc.) are still low. The course of the sintering process in multicomponent systems is largely determined by the nature of the corresponding phase diagrams.

There are various methods for producing finished ceramic samples, e.g. conventional ceramic process and hot pressing. Conventional ceramic process involves forming billets in a hydraulic press and sintering them in atmosphere in a high temperature oven. The hot pressing method additionally includes billet briquetting and sintering under pressure in a hot pressing machine.

According to the present invention, a method for alteration of the electrical and magnetic properties of ceramics includes preparing a batch mix containing initial components and, where necessary, certain alloying agents according to known technology; homogenization; saturation of the dry mixture (batch) with the declared modifier; baking the batch mix saturated with modifier; sintering the modifier saturated mixture according to the specified technology, to obtain the relevant ceramic sample and to further obtain a modified ceramic sample.

In addition, after the baking stage and before the sintering stage, the mixture saturated with modifier can be re-saturated with modifier (of the same composition or a different one), after which the mixture is ground, re-homogenized and sintered according to the required ceramic technology.

Additionally, after the baking stage and before the sintering stage, plasticizer is added to the modifier-saturated mixture, and the end product is formed.

Another method of changing the electrical and magnetic properties of ceramic samples will require a ready-made or baked ceramic sample, which is then ground and homogenized into powder. The powder is saturated with the relevant modifier, followed by sintering the modifier-saturated powder according to the technology method, to obtain the relevant ceramic sample.

The present invention is illustrated by the following examples, together with the accompanying drawings:

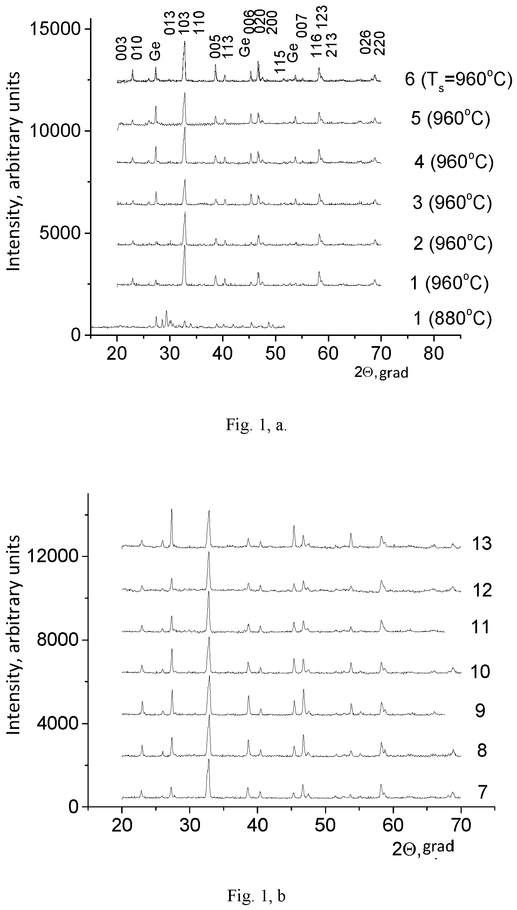

FIG.1a: Diffraction patterns of the synthesized samples Nos. 1-6 with the admixture of Ge crystal powder as an internal standard (on the right side of the diffraction patterns, the batch numbers of the samples and the baking temperature $T_s$ are given; above the reflections, the Miller indices of the corresponding crystallographic planes are given).

FIG. 1b. Diffraction patterns of the synthesized samples Nos.7-13 with the admixture of Ge crystal powder as an internal standard (the numbers on the right side of the diffraction patterns indicate the batch number of the samples; the baking temperature $T_s$=960°C).

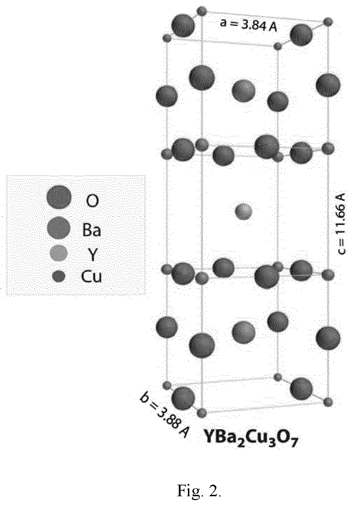

FIG.2. Rhombic cell $a,b,c$ of $YBa_2Cu_3O_7$ phase with Y, Ba, Cu, and O atoms.

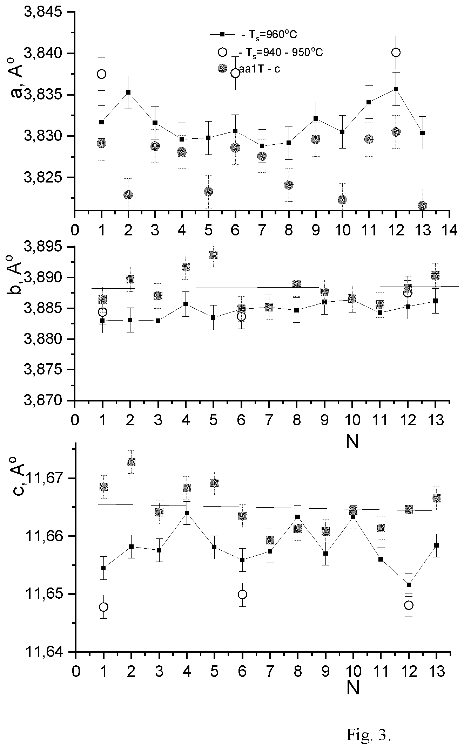

FIG.3. Dimensions of the rhombic cell of the HTSC phase $YBa_2Cu_3O_y$ in samples of batches Nos. 1-13 : black dots denoting the samples after baking and prior to pressing into tablets and sintering; red dots denoting the samples pressed into tablets and sintered; empty dots denoting the samples obtained at an intermediate stage of their synthesis at a temperature lower than the final synthesis temperature.

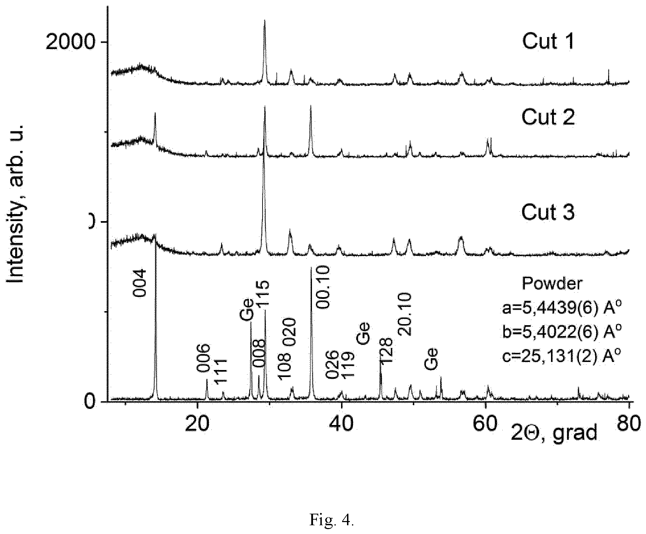

FIG.4. Diffraction patterns taken in □ - 2□ geometry from the powder obtained by grinding hot-pressed $Bi_3TiNbO_9$ samples and from the sections perpendicular (cut 2) and parallel (cuts 1 and 3) to the ceramic pressing axis (with the admixture of Ge crystal powder as an internal standard) and the results of their indexing. The Miller indices of the appropriate crystallographic planes are indicated above the reflections.

Example 1

Modifier preparation

Below is an example of obtaining a modifier by trituration with subsequent dilution of the resulting trituration in aqueous or aqueous-alcoholic solution to obtain a release-active form of silver nitrate (RA $AgNO_3$) in the form of a mixture of centesimal dilutions C12C30C50. For parent substance, dry silver nitrate powder ($AgNO_3$) is used. Lactose monohydrate is used as a neutral carrier in trituration.

To obtain successive triturations C1-C3 (centesimal scale, 1 unit of the parent substance or the previous trituration (C1 or C2) and 99 units of lactose monohydrate is taken), the following procedure is observed. The required amount of lactose monohydrate is divided into 3 equal portions. The first portion of lactose monohydrate is placed in a porcelain mortar and ground to close the pores of the mortar. Then the entire amount of the dry powdered silver nitrate is added, and the resulting mixture is ground with effort, after which the powder is raked with a spatula and scraped off the walls of the mortar; this operation is repeated once more. Then the second and the third portions of the neutral carrier are added sequentially. Thus, trituration C1 is obtained. Then, similar to the above process, C2 trituration is obtained (adding 1 unit of C1 trituration to 99 units of lactose) and C3 trituration (adding 1 unit of C2 trituration to 99 units of lactose).

The subsequent dilution C4 is obtained from 1 unit of the trituration of C3 and 99 units (centesimal scale) of 25% aqueous solution of ethyl alcohol. These components are thoroughly mixed until smooth, shaking the closed bottle vertically. C5 dilution is obtained from 1 unit of C4 dilution and 99 parts of 25% aqueous solution of ethyl alcohol, thoroughly mixing the indicated components until smooth, shaking vertically. The required degree of dilution is obtained by repeating the previous steps as appropriate.

Further, to obtain release-active silver nitrate in the form of a mixture of dilutions, according to this example, C12C30C50, centesimal dilutions are prepared according to the above-described technology until dilution which is 3 steps of centesimal dilutions less than the final solution of C12C30C50. For this dilution, C9, C27 and C47, one unit of each dilution (in this example, the volume ratio is 1:1:1) are put into one container containing 97 units of a 70% aqueous solution of ethyl alcohol (for centesimal dilution). The resulting mixture is then sequentially diluted twice in a ratio of 1 to 100, using 70% aqueous solution of ethyl alcohol at the penultimate stage, and 36% aqueous solution of ethyl alcohol at the last stage, thoroughly mixing these components until smooth, shaking the closed bottle with the resulting solution vertically after each dilution. At the last stage, modifier is obtained, a release-active form of silver nitrate (RA $AgNO_3$), by diluting silver nitrate by $100^{12}$, $100^{30}$, $100^{50}$ times, which in terms of homeopathic technology corresponds to a mixture of centesimal dilutions C12, C30 and C50.

The above-described method of obtaining modifier in the form of release-active dilutions of silver nitrate is one of the embodiments of this invention. To obtain a modifier according to the present invention, decimal, hundredth, thousandth aqueous or aqueous-alcoholic dilutions of the starting substance can be used, starting with C2 (i.e., with a dilution of the starting substance by $100^2$ times), as well as any combinations thereof (e.g. C2 + D34 + M45, D20 + C4, etc.) and their ratio in the mixture (for example, 1:1:2, 2:3, etc.).

Example 2

Obtaining a modified HTSC using the RA $AgNO_3$ modifier

To obtain the modified HTSC of the $YBa_2Cu_3O_{7-y}$ phase (Y-123), oxides $Y_2O_3$ (grade "ITO-2"), CuO ("extra pure grade 9-2"), $BaO_2$ ("pure grade") were used for initial components. To purify the reagents from the hygroscopic moisture oxides and impurities, such as carbon dioxide and others, adsorbed during storage, the reagents underwent incineration at 400-800°C before weighing.

For further synthesis of pure HTSC phase Y-123, mixtures of composition $Y_2O_3 \cdot 4BaO_2 \cdot 6CuO$ were prepared. The mix of components was then homogenized by stirring for an hour in ethanol in a Pulverisette-6 centrifugal ball mill. As a result, the size of the component particles decreased to a few micrometers.

The homogenized batch mixture was further saturated with a modifier, release-active silver nitrate (RA $AgNO_3$) in the form of a mixture of centesimal dilutions of C12C30C50, obtained according to Example 1. For this, 30 ml of RA $AgNO_3$ solution was added to 80g of the homogenized mixture and stirred with a spatula to obtain a homogeneous moist mixture. Then the resulting moist powder was dried at + 35°C for 6 hours until the liquid evaporated.

The samples treated with the modifier based on the Y-123 HTSC phase were synthesized via solid-phase reactions in an SNOL 12/16 furnace, in air. The batch mixes were repeatedly baked, sequentially increasing the maximum temperature from 870°C to 960°C. The resulting products were subject to intermediate grinding, and their phase composition was controlled by X-ray phase analysis method. In total, seven incinerations were carried out.

Taking into account the data on low melting temperatures ($T_m$) of $AgNO_3$ ($T_m$=210°C) and decomposition temperatures ($T_{dec}$) of $BaO_2$ ($T_{dec} \approx 500$°C), the first baking was carried out with an intermediate exposure at 240°C for five hours, and with slow heating to the maximum baking temperature. The latter was relatively low (870°C). Such first baking scheme is due to the need to ensure smooth entry of Ag and Ba atoms into the Y-123 crystal lattice formed during the baking, in order to obtain samples with a uniform distribution of chemical components over the volume.

The synthesis yielded polycrystalline samples in the form of black homogeneous-looking powders.

Before molding, the powders were ground in mortars together with ~1 wt% of 5% aqueous solution of polyvinyl alcohol (PVA) for better homogenization. Molding was performed using a Shimadzu hydraulic press and a set of appropriate molds.

The billets obtained after molding were sintered in air in a SNOL 12/16 furnace at 960°C. First, the samples underwent a 5-hour heating to 150°C, and then were kept at this temperature for an hour (in order to achieve smooth removal of PVA from the samples). Then the samples underwent a 5-hour temperature increase from 150°C to 960°C and were kept at 960°C for 3 hours (ceramic sintering). Then the furnace temperature was slowly lowered to 300°C (over 40 hours) and the samples were kept at 300°C for 30 hours, after which the samples were removed from the furnace. The slow cooling from 960°C to 300°C and the long exposure at 300°C was employed to ensure the entry of oxygen from the surrounding atmosphere into the Y-123 HTSC phase and to achieve the "y" oxygen index of the Y-123 phase ($YBa_2Cu_3O_y$, y ≈ 6.8-7.0).

After the final sintering, the structure of the samples was analyzed on an X-ray diffraction meter. The diffraction patterns of the samples correspond to the literature data on the $YBa_2Cu_3O_{7-y}$ phase in terms of the position and reflections intensities [see Example 9].

Example 3

Obtaining a modified HTSC containing alloying agent $AgNO_3$ using the RA $AgNO_3$ modifier

To obtain the modified HTSC of the $YBa_2Cu_3O_{7-y}$ phase (Y-123), oxides $Y_2O_3$ (grade "ITO-2"), CuO ("extra pure grade 9-2"), $BaO_2$ ("pure grade") and silver nitrate $AgNO_3$ ("chemically pure grade") were used for initial components. To purify the reagents from the hygroscopic moisture oxides and impurities, such as carbon dioxide and others, adsorbed during storage, the reagents underwent incineration at 400-800°C before weighing.

For further synthesis of HTSC phase Y-123 with admixtures of silver atoms, 200 g of mixture of $Y_2O_3 \cdot 4BaO_2 \cdot 6CuO$ + 5wt% of $AgNO_3$ were prepared. The mix of components was then homogenized by stirring for an hour in ethanol in a Pulverisette-6 centrifugal ball mill.

The homogenized batch mixture was further saturated with a modifier, release-active silver nitrate (RA $AgNO_3$) in the form of a mixture of centesimal dilutions of C12C30C50, obtained according to Example 1. For this, 30 ml of RA $AgNO_3$ solution was added to 80g of the homogenized mixture and stirred with a spatula to obtain a homogeneous moist mixture. Then the resulting moist powder was dried at + 35°C for 6 hours until the liquid evaporated.

The samples treated with the modifier based on the Y-123 HTSC phase were synthesized via solid-phase reactions in an SNOL 12/16 furnace, in air. The batch mixes were repeatedly baked, sequentially increasing the maximum temperature from 870°C to 960°C. The resulting products were subject to intermediate grinding, and their phase composition was controlled by X-ray phase analysis method. In total, seven incinerations were carried out. The synthesis yielded polycrystalline samples in the form of black homogeneous-looking powders.

Before molding, the powders were ground in mortars together with ~1 wt% of 5% aqueous solution of polyvinyl alcohol (PVA) for better homogenization. Molding was performed using a Shimadzu hydraulic press and a set of appropriate molds.

The billets obtained after molding were sintered in air in a SNOL 12/16 furnace at 960°C. First, the samples underwent a 5-hour heating to 150°C, and then were kept at this temperature for an hour (in order to achieve smooth removal of PVA and its decomposition products from the samples). Then the samples underwent a linear 5-hour temperature increase from 150°C to 960°C and were kept at 960°C for 3 hours (ceramic sintering). Then the furnace temperature was slowly lowered to 300°C (over 40 hours) and the samples were kept at 300°C for 30 hours, after which the samples were removed from the furnace. The slow cooling from 960°C to 300°C and long exposure at 300°C was employed to ensure the entry of oxygen from the surrounding atmosphere into the Y-123 HTSC phase and to achieve the "y" oxygen index of the Y-123 phase ($YBa_2Cu_3O_y$, $y \approx 6.8\text{-}7.0$).

After the final sintering, the structure of the samples was analyzed on an X-ray diffraction meter. The diffraction patterns of the samples correspond to the literature data on the $YBa_2Cu_3O_{7-y}$ phase in terms of the position and reflections intensities [see Example 9].

Example 4

Obtaining a modified HTSC using the RA CuO modifier (double modifier treatment)

To obtain the modified HTSC of the $YBa_2Cu_3O_{7-y}$ phase (Y-123), oxides $Y_2O_3$ (grade "ITO-2"), CuO ("extra pure grade 9-2"), $BaO_2$ ("pure grade") were used for initial components. To purify the reagents from the hygroscopic moisture oxides and impurities, such as carbon dioxide and others, adsorbed during storage, the reagents underwent incineration at 400-800°C before weighing.

For further synthesis of pure HTSC phase Y-123, mixtures with composition $Y_2O_3 \cdot 4BaO_2 \cdot 6CuO$ were prepared. The mix of components was then homogenized by stirring for an hour in ethanol in a Pulverisette-6 centrifugal ball mill.

The homogenized batch mixture was further saturated with a modifier, release-active copper oxide (RA CuO) in the form of a mixture of dilutions of D50D20, obtained according to Example 1. For this, 22.5 ml of RA CuO solution was added to 60g of the homogenized mixture and stirred with a spatula to obtain a homogeneous moist mixture. Then the resulting moist powder was dried at + 35°C for 6 hours until the liquid evaporated.

The samples treated with release-active copper oxide dilutions based on the Y-123 HTSC phase were synthesized via solid-phase reactions in an SNOL 12/16 furnace, in air. The batch mixes were repeatedly baked, sequentially increasing the maximum temperature from 870°C to 960°C. The resulting products were subject to intermediate grinding, and their phase composition was controlled by X-ray phase analysis method. In total, three incinerations were carried out. The synthesis yielded polycrystalline samples in the form of black homogeneous-looking powders.

After the baking, the resulting powder was re-saturated with modifier, i.e. release-active form of copper oxide (RA CuO) in the form of a mixture of dilutions D50D200 in a ratio of 1:2, according to the method disclosed in Example 1. For this, 30 ml of RA solution was added to 80 g of the CuO powder, and stirred with a spatula to obtain a homogeneous moist mixture. Then the resulting moist powder was dried at + 35°C for 6 hours until the liquid evaporated.

Before molding, the powders were ground in mortars together with ~1 wt% of 5% aqueous solution of polyvinyl alcohol (PVA) for better homogenization. Molding was performed using a Shimadzu hydraulic press and a set of appropriate molds.

The billets obtained after molding were sintered in air in a SNOL 12/16 furnace at 960°C. First, the samples underwent a 5-hour heating to 150°C, and then were kept at this temperature for an hour (in order to achieve smooth removal of PVA and its decomposition products from the samples). Then the samples underwent a linear 5-hour temperature increase from 150°C to 960°C and were kept at 960°C for 3 hours (ceramic sintering). Then the furnace temperature was slowly lowered to 300°C (over 40 hours) and the samples were kept at 300°C for 30 hours, after which the samples were removed from the furnace. The slow cooling from 960°C to 300°C and long exposure at 300°C was employed to ensure the entry of oxygen from the surrounding atmosphere into the Y-123 HTSC phase and to achieve the "y" oxygen index of the Y-123 phase ($YBa_2Cu_3O_y$, $y \approx 6.8\text{-}7.0$), optimal from the point of view of superconducting properties.

After the final sintering, the structure of the samples was analyzed on an X-ray diffraction meter. The diffraction patterns of the samples correspond to the literature data on the $YBa_2Cu_3O_{7-y}$ phase in terms of the position and reflections intensities [see Example 9].

Example 5

Obtaining a modified HTSC using the RA HTSC modifier of the $YBa_2Cu_3O_{7-y}$ phase obtained after the sintering stage

To obtain the modified HTSC of $YBa_2Cu_3O_{7-y}$ phase (Y-123), previously obtained HTSC of Y-123 phase was used for initial component. The resulting powder was then homogenized by stirring for an hour in ethanol in a Pulverisette-6 centrifugal ball mill.

The homogenized powder was further saturated with modifier, release-active HTSC of $YBa_2Cu_3O_{7-y}$ phase obtained after the sintering stage (PA $YBa_2Cu_3O_{7-y}$) in the form of a mixture of centesimal dilutions of C12C30C50, obtained according to the procedure described in Example 1. For this, 22.5 ml of RA $YBa_2Cu_3O_{7-y}$ solution was added to 60g of the homogenized mixture and stirred with a spatula to obtain a homogeneous moist mixture. Then the resulting moist powder was dried at + 35°C for 6 hours until the liquid evaporated.

Before molding, the powders were ground in mortars together with ~1 wt% of 5% aqueous solution of polyvinyl alcohol (PVA) for better homogenization. Molding was performed using a Shimadzu hydraulic press and a set of appropriate molds.

The billets obtained after molding were sintered in air in a SNOL 12/16 furnace at 960°C. First, the samples underwent a 5-hour heating to 150°C, and then were kept at this temperature for an hour (in order to achieve smooth removal of PVA and its decomposition products from the samples). Then the samples underwent a linear 5-hour temperature increase from 150°C to 960°C and were kept at 960°C for 3 hours (ceramic sintering). Then the furnace temperature was slowly lowered to 300°C (over 40 hours) and the samples were kept at 300°C for 30 hours, after which the samples were removed from the furnace. The slow cooling from 960°C to 300°C and long exposure at 300°C was employed to ensure the entry of oxygen from the surrounding atmosphere into the Y-123 HTSC phase and to achieve the "y" oxygen index of the Y-123 phase ($YBa_2Cu_3O_y$, $y \approx 6.8-7.0$), optimal from the point of view of superconducting properties.

After the final sintering, the structure of the samples was analyzed on an X-ray diffraction meter. The diffraction patterns of the samples correspond to the literature data on the $YBa_2Cu_3O_{7-y}$ phase in terms of the position and reflections intensities [see Example 9].

Example 6

Obtaining a modified HTSC using the batch mix of RA HTSC modifier of the $YBa_2Cu_3O_{7-y}$ phase

To obtain the modified HTSC of the $YBa_2Cu_3O_{7-y}$ phase (Y-123), oxides $Y_2O_3$ (grade "ITO-2"), CuO ("extra pure grade 9-2"), $BaO_2$ ("pure grade") were used for initial components. To purify the reagents from the hygroscopic moisture oxides and impurities, such as carbon dioxide and others, adsorbed during storage, the reagents underwent incineration at 800°C before weighing.

For further synthesis of pure HTSC phase Y-123, batch mixtures with composition $Y_2O_3 \cdot 4BaO_2 \cdot 6CuO$ were prepared. The mix of components was then homogenized by stirring for an hour in ethanol in a Pulverisette-6 centrifugal ball mill. As a result, the size of the component particles decreased to a few micrometers.

The homogenized batch mixture was further saturated with a modifier, release-active form of $Y_2O_3 \cdot 4BaO_2 \cdot 6CuO$ batch mix in the form of a mixture of dilutions of C12C30C50, obtained according to Example 1. For this, 30 ml of $Y_2O_3 \cdot 4BaO_2 \cdot 6CuO$ release-active batch mix solution was added to 80g of the homogenized batch mix and stirred with a spatula to obtain a homogeneous moist mixture. Then the resulting moist powder was dried at + 35°C for 6 hours until the liquid evaporated.

The samples treated with release-active form of $Y_2O_3 \cdot 4BaO_2 \cdot 6CuO$ batch mix based on the Y-123 HTSC phase were synthesized via solid-phase reactions in an SNOL 12/16 furnace, in air. The batch mixes were repeatedly baked, sequentially increasing the maximum temperature from 870°C to 960°C. The resulting products were subject to intermediate grinding, and their phase composition was controlled by X-ray phase analysis method. In total, seven incinerations were carried out. The synthesis yielded polycrystalline samples in the form of black homogeneous-looking powders.

Before molding, the powders were ground in mortars together with ~1 wt% of 5% aqueous solution of polyvinyl alcohol (PVA) for better homogenization. Molding was performed using a Shimadzu hydraulic press and a set of appropriate molds.

The billets obtained after molding were sintered in air in a SNOL 12/16 furnace at 960°C. First, the samples underwent a 5-hour heating to 150°C, and then were kept at this temperature for an hour (in order to achieve smooth removal of PVA from the samples). Then the samples underwent a linear 5-hour temperature increase from 150°C to 960°C and were kept at 960°C for 3 hours (ceramic sintering). Then the furnace temperature was slowly lowered to 300°C (over 40 hours) and the samples were kept at 300°C for 30 hours, after which the samples were removed from the furnace. The slow cooling from 960°C to 300°C and long exposure at 300°C was employed to ensure the entry of oxygen from the surrounding atmosphere into the Y-123 HTSC phase and to achieve the "y" oxygen index of the Y-123 phase ($YBa_2Cu_3O_y$, y ≈ 6.8-7.0), optimal from the point of view of superconducting properties.

After the final sintering, the structure of the samples was analyzed on an X-ray diffraction meter. The diffraction patterns of the samples correspond to the literature data on the $YBa_2Cu_3O_{7-y}$ phase in terms of the position and reflections intensities [see Example 9].

Example 7

Obtaining a modified HTSC using the RA powder modifier of the $YBa_2Cu_3O_{7-y}$ phase obtained after the first baking

To obtain the modified HTSC of the $YBa_2Cu_3O_{7-y}$ phase (Y-123), oxides $Y_2O_3$ (grade "ITO-2"), CuO ("extra pure grade 9-2"), $BaO_2$ ("pure grade") were used for initial components. To purify the reagents from the hygroscopic moisture oxides and impurities, such as carbon dioxide and others, adsorbed during storage, the reagents underwent incineration at 800°C before weighing.

For further synthesis of pure HTSC phase Y-123, batch mixtures with composition $Y_2O_3 \cdot 4BaO_2 \cdot 6CuO$ were prepared. The mix of components was then homogenized by stirring for an hour in ethanol in a Pulverisette-6 centrifugal ball mill. As a result, the size of the component particles decreased to a few micrometers.

The samples based on the Y-123 HTSC phase were synthesized via solid-phase reactions in an SNOL 12/16 furnace, in air. The batch mixes were repeatedly baked, sequentially increasing the maximum temperature from 870°C to 960°C. The resulting products were subject to intermediate grinding, and their phase composition was controlled by X-ray phase analysis method. In total, seven incinerations were carried out. The synthesis yielded polycrystalline samples in the form of black homogeneous-looking powders with already formed HTSC structure.

The powder samples (after baking) were further saturated with a modifier, release-active $YBa_2Cu_3O_{7-y}$, obtained after the baking, in the form of a mixture of centesimal dilutions of C12C30C50, obtained according to Example 1. For this, 22.5 ml of RA $YBa_2Cu_3O_{7-y}$ solution was added to 60g of the homogenized mixture and stirred with a spatula to obtain a homogeneous moist mixture. Then the resulting moist powder was dried at + 35°C for 6 hours until the liquid evaporated.

Before molding, the powders were ground in mortars together with ~1 wt% of 5% aqueous solution of polyvinyl alcohol (PVA) for better homogenization. Molding was performed using a Shimadzu hydraulic press and a set of appropriate molds.

The billets obtained after molding were sintered in air in a SNOL 12/16 furnace at 960°C. First, the samples underwent a 5-hour heating to 150°C, and then were kept at this temperature for an hour (in order to achieve smooth removal of PVA from the samples). Then the samples underwent a linear 5-hour temperature increase from 150°C to 960°C and were kept at 960°C for 3 hours (ceramic sintering). Then the furnace temperature was slowly lowered to 300°C (over 40 hours) and the samples were kept at 300°C for 30 hours, after which the samples were removed from the furnace. The slow cooling from 960°C to 300°C and long exposure at 300°C was employed to ensure the entry of oxygen from the surrounding atmosphere into the Y-123 HTSC phase and to achieve the "y" oxygen index of the Y-123 phase ($YBa_2Cu_3O_y$, y ≈ 6.8-7.0), optimal from the point of view of superconducting properties.

After the final sintering, the structure of the samples was analyzed on an X-ray diffraction meter. The diffraction patterns of the samples correspond to the literature data on the $YBa_2Cu_3O_{7-y}$ phase in terms of the position and reflections intensities [see Example 9].

Example 8

Obtaining a modified HTSC using the modifier of the RA batch mix of $Y_2O_3$, $BaO_2$, CuO before the primary baking and the RA phase of $YBa_2Cu_3O_{7-y}$ (after baking) before sintering

To obtain the modified HTSC of the $YBa_2Cu_3O_{7-y}$ phase (Y-123), oxides $Y_2O_3$ (grade "ITO-2"), CuO ("extra pure grade 9-2"), $BaO_2$ ("pure grade") were used for initial components. To purify the reagents from the hygroscopic moisture oxides and impurities, such as carbon dioxide and others, adsorbed during storage, the reagents underwent incineration at 800°C before weighing.

For further synthesis of pure HTSC phase Y-123, batch mixtures with composition $Y_2O_3 \cdot 4BaO_2 \cdot 6CuO$ were prepared. The mix of components was then homogenized by stirring for an hour in ethanol in a Pulverisette-6 centrifugal ball mill. As a result, the size of the component particles decreased to a few micrometers.

The homogenized batch mixture was further saturated with a modifier, release-active form of $Y_2O_3 \cdot 4BaO_2 \cdot$

6CuO batch mix in the form of a mixture of centesimal dilutions of C12C30C50, obtained according to Example 1. For this, 30 ml of release-active solution of the same batch mix was added to 80g of the homogenized batch mix and stirred with a spatula to obtain a homogeneous moist mixture. Then the resulting moist powder was dried at + 35°C for 6 hours until the liquid evaporated.

The modifier-treated samples based on the Y-123 HTSC phase were synthesized via solid-phase reactions in an SNOL 12/16 furnace, in air. The batch mixes were repeatedly baked, sequentially increasing the maximum temperature from 870°C to 960°C. The resulting products were subject to intermediate grinding, and their phase composition was controlled by X-ray phase analysis method. In total, seven incinerations were carried out. The synthesis yielded polycrystalline samples in the form of black homogeneous-looking powders.

The powder samples (after baking) were once more saturated with another modifier, release-active HTSC form of $YBa_2Cu_3O_{7-y}$, obtained after the baking, in the form of a mixture of centesimal dilutions of C12C30C50, obtained according to Example 1. For this, 22.5 ml of the same batch mix solution was added to 60g of the homogenized mixture and stirred with a spatula to obtain a homogeneous moist mixture. Then the resulting moist powder was dried at + 35°C for 6 hours until the liquid evaporated.

Before molding, the powders were ground in mortars together with ~1 wt% of 5% aqueous solution of polyvinyl alcohol (PVA) for better homogenization. Molding was performed using a Shimadzu hydraulic press and a set of appropriate molds.

The billets obtained after molding were sintered in air in a SNOL 12/16 furnace at 960°C. First, the samples underwent a 5-hour heating to 150°C, and then were kept at this temperature for an hour (in order to achieve smooth removal of PVA from the samples). Then the samples underwent a linear 5-hour temperature increase from 150°C to 960°C and were kept at 960°C for 3 hours (ceramic sintering). Then the furnace temperature was slowly lowered to 300°C (over 40 hours) and the samples were kept at 300°C for 30 hours, after which the samples were removed from the furnace. The slow cooling from 960°C to 300°C and long exposure at 300°C was employed to ensure the entry of oxygen from the surrounding atmosphere into the Y-123 HTSC phase and to achieve the "y" oxygen index of the Y-123 phase ($YBa_2Cu_3O_y$, $y \approx 6.8$-$7.0$), optimal from the point of view of superconducting properties.

After the final sintering, the structure of the samples was analyzed on an X-ray diffraction meter. The diffraction patterns of the samples correspond to the literature data on the $YBa_2Cu_3O_{7-y}$ phase in terms of the position and reflections intensities [see Example 9].

Example 9

Results of X-ray phase analysis of all obtained samples

The following samples of superconducting ceramics were analyzed:

Sample 1: A mixture of powders (batch mix) treated with RA mix batch of $Y_2O_3$, $BaO_2$, CuO composition (C12C30C50) before the primary baking, and a mixture of powders after the first baking, treated with RA $YBa_2Cu_3O_{7-y}$ (C12C30C50) before sintering;

Sample 2: A mixture of powders (batch mix) treated with RA mix batch of $Y_2O_3$, $BaO_2$, CuO composition (C12C30C50) before the primary baking, and a mixture of powders after the first baking, treated with in-process monitoring before sintering, in-process monitoring;

Sample 3: A mixture of powders (batch mix) treated with RA mix batch of $Y_2O_3$, $BaO_2$, CuO composition (C12C30C50) before the primary baking, and a mixture of powders after the first baking, treated with 36.7% ethanol before sintering, monitoring (without SVR components);

Sample 4: A mixture of powders (batch mix) treated with RA mix batch of $Y_2O_3$, $BaO_2$, CuO composition (C12C30C50) before the primary baking;

Sample 5: A mixture of powders (batch mix) treated with in-process monitoring, release-active lactose;

Sample 6: A mixture of powders (batch mix) treated with 36.7% ethanol, monitoring (without RA components);

Sample 7: Powder with already formed HTSC structure $YBa_2Cu_3O_{7-y}$ before its sintering into ceramics, treated with RA powder of $YBa_2Cu_3O_{7-y}$ phase (C12C30C50) obtained before the first sintering;

Sample 8: Powder with already formed HTSC structure $YBa_2Cu_3O_{7-y}$ before its sintering into ceramics, treated with in-process monitoring;

Sample 9: Powder with already formed HTSC structure $YBa_2Cu_3O_{7-y}$ before its sintering into ceramics, treated with 36.7% ethanol, monitoring (without RA components);

Sample 10: A mixture of powders (batch mix) treated with RA $AgNO_3$ (C12C30C50);

Sample 11: A mixture of powders with admixture of $AgNO_3$ (batch mix) treated with RA $AgNO_3$ (C12C30C50);

Sample 12: A mixture of powders with admixture of $AgNO_3$ (batch mix) treated with in-process monitoring;

Sample 13: Intact mixture of $Y_2O_3$, $BaO_2$, CuO powders (batch mix) without additives and treatments, prepared according to standard procedure (general control).

X-ray phase analysis (XPA) of all samples after their synthesis and after sintering was performed on an automated DRON-4 X-ray diffraction meter using filtered copper radiation and Ge crystal powder as an internal standard.

Diffraction patterns of the samples (Fig. 1a and 1b), by their positions and reflection intensities correspond to the literature data on the $YBa_2Cu_3O_{7-y}$ phase [Powder Diffraction files of the International Center for Diffraction Data (ICDD). Accessed 7 Dec 2020. https://www.icdd.com/pdfsearch/, Bush A.A. Synthesis of metal oxide superconductors. High-temperature superconductivity, intersectoral scientific and technical almanac. Moscow: VIMI, 1989, issue 1, pp. 57-67. Bush A.A. Technology of ceramic materials, peculiarities of obtaining ceramics of HTSC phase $YBa_2Cu_3O_{7-y}$ phase. Moscow: MIREA, 2000, p. 79]. All reflections of diffraction patterns of the samples baked at 960°C, as well as the sintered samples, refer to the Y-123 based phase, with no significant impurity reflections observed. In this regard, it can be concluded that the synthesized samples are practically single-phase, they consist of an HTSC phase based on Y-123.

The diffraction pattern of sample No.1 (Fig. 1a) obtained after baking at 880°C contains many reflections that are not indicated on the basis of the HTSC unit cell parameters of Y-123 phase, which indicates the multiphase nature of this sample and the insufficiency of baking temperature of 880°C to obtain the Y-123 phase by the solid-phase reactions method.

Using the data of precision measurements of the Bragg angles of X-ray reflections 2□ (the measurement error not exceeding 0.02°) and the special-purpose software "CELREF for unit cell refinement" [http://www.ccp14.ac.uk/tutorial/lmgp/celref.htm (CELREF for unit cell refinement)], all the diffraction patterns obtained from samples 1 to 13 (Fig. 1a,b) were indexed on the basis of a rhombic unit cell where a=3.82, b=3.88 and c=11.66Å (Fig. 2). As a result of the indexing, data were obtained on the refined unit cell dimensions for the Y-123 high-temperature superconducting phase in all synthesized and sintered samples No. 1-13 (Fig. 3).

It can be noted that, in a first approximation, the unit cell dimensions of the Y-123 HTSC phase correspond to the known literature data on this phase. However, a precise comparison of the unit cell sizes shows a scatter of their Y-123 phase values in different batches of synthesized samples, and also in the samples obtained after their synthesis and after sintering, respectively (Fig. 3). This data variability is most likely caused by uncontrolled variations in the oxygen index "y" of the samples under consideration, caused by the effect of RA treatment.

Example 10

Assessment of the temperature dependence of electrical resistance

Electrical resistance R of the samples was measured using the four-probe method; the survey current in all cases was 50 mA. An RHTS-100 platinum thermometer (Honeywell, USA) was used for temperature sensor; its resistance was measured with a GOM 802 DC milliohm meter (GW-Instek, Taiwan), and the voltage across the potential contacts of the sample was measured with a V7-78/1 voltmeter (AKIP, Russia). The data yielded by these devices were fed into a computer and recorded into a file for further processing.

A sharp drop in resistance is observed on R(T) dependences upon transition to the SC state, while three characteristic sections can be distinguished on R(T) dependence: (a) an almost horizontal high-temperature section in the normal state of the sample; (b) a section with a sharp drop in resistance, with co-existent normal and LF phases caused by LF transition; (c) a low-temperature section with low resistance determined by the motion of LF vortices (flux flow region, FF). Five temperatures are usually distinguished as the temperatures characterizing the SP transition: the temperature of the beginning of the transition T1, at which the resistance decreases to $0.9 R_n$ ($R_n$ being the resistance in the normal state near $T_c$); the temperature of the end of the transition T3, at which the resistance decreases to $0.1 R_n$; the temperature of the beginning of the SC fluctuations T2, determined by the onset of the deviation of the dependence R(T) from the linear law; the temperature of the middle of the transition T4, at which $R = 0.5R_n$; FF is the temperature of the end of the SP transition, below which the resistance is determined by the motion of the SP vortices.

The following samples were used for the analysis:

Sample 1: A mixture of powders (batch mix) treated with RA mix batch of $Y_2O_3$, $BaO_2$, CuO composition (C12C30C50) before the primary baking;
Sample 2: A mixture of powders with admixture of $AgNO_3$ (batch mix) treated with RA $AgNO_3$ (C12C30C50);
Sample 3: Intact mixture of powdered $Y_2O_3$, $BaO_2$, CuO (batch mix) without admixtures, un-processed, prepared according to standard procedure (general supervision).

The results of the obtained measurements are presented in Table 1 (Typical temperatures of the SC transition determined according to R(T) dependences).

Table 1: Typical temperatures of the SC transition determined according to R(T) dependences

| # | T1, K | T3, K | $T_{FF}$, K |
|---|-------|-------|-------------|
| 1 | 89.0 | 85.9 | 83.3 |
| 2 | 89.3 | 88.2 | 87.0 |
| 3 | 86.3 | 83.9 | 82.9 |

An increase in FF temperature was manifest upon addition of a ligand, together with a modifier in the form of the RA $AgNO_3$.

Conclusion:

Even a slight increase in the $T_{FF}$ temperature makes it possible to stabilize the magnetic state of the superconductor and to eliminate the danger of magnetic flux jumps at the temperature of liquid nitrogen, which simplifies the formation of magnetic systems using this material.

Example 11

Measurement of the real part of the magnetic susceptibility (Meissner effect)

In a superconducting transition, the real part of the magnetic susceptibility $\chi'(\omega)$ in an alternating magnetic field of small amplitude changes from 0 in the normal value to the minimum value $\chi'_{min}$ in the SC state. This is due to the expulsion of the magnetic field from the bulk of the sample during the SC transition. At low frequencies (<10 kHz) and for constant external magnetic field, this behavior is called Meissner effect.

For an ideal type I superconductor, the magnetic susceptibility takes on the value of -1. In mixed state, the value $\chi'$ can take values of the range [-1; 0], which is determined by the fraction of the superconducting phase in the sample.

If an inductance coil ($L_0$) is available where the sample under analysis is used as the core, then, in the course of SC transition, its inductance will decrease to $L_1$, which is determined by the fraction of the SC phase volume in the core. Thus, $\Delta L = L_1 - L_0$ turns out to be proportional to the real part of the magnetic susceptibility $\chi'(\omega)$.

The temperature values typical for the SC transition can be obtained from the graphs of the temperature dependences of the real part of the magnetic susceptibility $\chi'$ and its temperature derivative:

- temperature of the onset of the superconducting transition $T_{max}$, at which a sufficient amount of the superconducting phase emerges, forming a closed loop with a current in the sample;
- temperature of the end of the superconducting transition $T_{min}$, at which almost the entire sample goes over into the SC state, and the field is pushed out of the bulk (Meissner effect);
- temperature $T_{01}$, at which almost the entire sample remains in a mixed state, the magnetic field penetrating the entire volume;
- temperature $T_m$ at which the maximum of the derivative $d\chi'(T)/dT$ is observed;
- temperature $T_d$ at which the first SC fluctuations appear in the sample; as a rule, there is still no closed conducting loop.

Thus, from the $\chi'(T)$ diagrams show the onset $T_{max}$ and the end $T_{min}$ temperatures of the transition to the SC state, and also the temperatures $T_{01}$, $T_m$ and $T_d$, the width of the SC transition ($T_{max}-T_{min}$), and the magnitude of the Meissner effect in percent with respect to the reference sample.

The following samples were used for the analysis:

Sample 1: A mixture of powders (batch mix) treated with RA mix batch of $Y_2O_3$, $BaO_2$, CuO composition (C12C30C50) before the primary baking;
Sample 2: A mixture of powders with admixture of $AgNO_3$ (batch mix) treated with RA $AgNO_3$ (C12C30C50);
Sample 3: A mixture of powders with admixture of $AgNO_3$ (batch mix) treated with in-process monitoring;
Sample 4: Intact mixture of powdered $Y_2O_3$, $BaO_2$, CuO (batch mix) without admixtures, un-processed, prepared according to standard procedure (general supervision).

The measurements were carried out on specimens in the shape of cylindrical disks 10 mm in diameter and 2 mm thick. The temperature was measured with an RHTS-100 platinum thermometer (Honeywell, USA). The inductance of the measuring coil was measured by an E7-20 LCR meter manufactured by MNIPI (Minsk, Belarus).

Table 2: Superconducting transition temperatures obtained from magnetic measurements

| # | $T_{min}$ | $T_{max}$ | $T_{01}$ | $-\chi$, % | $T_m$ | $T_d$ | Notes |
|---|---|---|---|---|---|---|---|
| 1 | 84.3 | 90.5 | 88.5 | 92 | 87.5 | 91.0 | |
| 2 | 82.3 | 89.6 | 88.4 | 96 | 87.7 | 91 | 2 SC transitions |
| 3 | 82.5 | 90.2 | 89.5 | 88 | 87.9 | 90.9 | 2 SC transitions |
| 4 | 86.0 | 91.2 | 89.8 | 85 | 89.2 | 92 | |

Addition of a ligand led to an increase in the magnitude of the Meissner effect, while the use of a modifier in the form of release-active $AgNO_3$ together with the ligand gave an even greater increase in this indicator compared to the reference values.

Conclusion:

An increase in the proportion of the superconducting phase in the sample volume improves the properties of superconducting screens and magnetic suspensions made on its basis. The stability of the trapped magnetic flux increases, the shielding time constant increases, etc.

Example 12

Measurement of the imaginary part of magnetic susceptibility

The absorption of the energy of the electromagnetic field by substance at a given frequency can be characterized by the imaginary part of magnetic susceptibility $\chi''(\omega)$. For a coil with a core made of the material under test, the following simple relationship can be introduced:

$$1/Q = 1/Q_0 + 1/Q_s ,$$

where $1/Q$ is the overall loss in the inductor with a core, $1/Q_0$ is the loss in the inductor without a core, $1/Q_s$ is the loss in the core, $Q_{o,s}$ is the Q factor of the measuring coil without (0) and with the sample (s).

For the operational frequencies of the coil (such that radiation losses and inter-turn capacitance can be neglected, $f = \omega/2\pi = 1$ - 100 kHz) $Q_0 = L \cdot \omega/R$. Where the quality factor of the coil with the core is large ($Q \gg 1$), it can be demonstrated that the value of $1/Q_s$ is proportional to the imaginary part of magnetic susceptibility $\chi''(\omega)$ and the fraction of the internal volume of the coil occupied by the core material. In the event when the superconductor is placed in the inductance coil, losses will increase in the zone of the superconducting transition (point FF), where an important role is played by the motion of Abrikosov vortices and fluctuations in the superconducting phase fraction, reaching a maximum (point RF, where the length of the electromagnetic wave in the substance becomes comparable to the size of the sample) and then drop sharply (point CR where an external alternating magnetic field is pushed out of the sample).

The following samples were used for the analysis:

Sample 1: A mixture of powders (batch mix) treated with RA mix batch of $Y_2O_3$, $BaO_2$, CuO composition (C12C30C50) before the primary baking, and a mixture of powders after the first baking treated by in-process monitoring before sintering, in-process monitoring;
Sample 2: A mixture of powders (batch mix) treated with RA mix batch of $Y_2O_3$, $BaO_2$, CuO composition (C12C30C50) before the primary baking;
Sample 3: A mixture of powders with admixture of $AgNO_3$ (batch mix) treated with RA $AgNO_3$ (C12C30C50);
Sample 4: Intact mixture of powdered $Y_2O_3$, $BaO_2$, CuO (batch mix) without admixtures, un-processed, prepared according to standard procedure (general supervision).

Table 3: Temperatures characterizing the SC transition obtained from graphs $\chi''$ (T).

| # | $T_{CR}$, K | $T_{RF0}$, K | $T_{FF}$, K | SC transition width, K |
|---|---|---|---|---|
| 1 | 85.4 | 87 | 90.7 | 5.3 |
| 2 | 85 | 88 | 89.7 | 4.7 |
| 3 | 84.7 | 88.5 | 90.4 | 5.7 |
| 4 | 82.1 | 86.5 | 88.3 | 6.2 |

Conclusion:

According to the data obtained, in comparison with the reference value (Sample 4), the use of the announced modifier led to an increase in the $T_{CR}$ $T_{RF0}$ $T_{FF}$ values, while Sample 2 demonstrated the minimum width of the SC transition, which characterizes the required abrupt SC transition.

An increase in the superconducting transition temperature and a decrease in its width have a beneficial effect on practically all possible applications of this superconductor.

Example 13

Measurement of the critical current density

Measurement of the critical current density of samples by their current-voltage characteristics

The following samples were used for the analysis:

Sample 1: A mixture of powders (batch mix) treated with RA mix batch of $Y_2O_3$, $BaO_2$, CuO composition (C12C30C50) before the primary baking;
Sample 2: A mixture of powders (batch mix) treated with RA $AgNO_3$ (C12C30C50);
Sample 3: A mixture of powders with admixture of $AgNO_3$ (batch mix) treated with RA $AgNO_3$ (C12C30C50);
Sample 4: Intact mixture of powdered $Y_2O_3$, $BaO_2$, CuO (batch mix) without admixtures, un-processed, prepared according to standard procedure (general supervision).

The density of the intergranular critical current $j_{ce}$ of the samples was measured according to the results of the assessment of their current-voltage characteristics in liquid nitrogen. In this case, the $j_{ce}$ value was measured according to the criterion of $1\mu V$ /cm. According to this criterion, the current density at which a sample displays a voltage of 1 $\mu V/cm$, is taken as $j_{ce}$. To expand the range of the measured $j_{ce}$ in the middle part of the sample under examination, it was narrowed by grinding with a diamond file. The research results are shown in Table 4.

Table 4: Critical current density $j_{ce}$ measured based on current-voltage characteristic (CVC) according to the criterion of 1 $\mu V/cm$

| Sample number | $j_{ce}$, A/cm$^2$ |
|---|---|
| 1 | 61.5 |
| 2 | 53 |
| 3 | 36 |
| 4 | 43 |

The experiment has confirmed an increase in the critical current density $j_e$ with the use of the announced modifier.

Conclusion:

Increasing the critical current is one of the most important factors in the field of obtaining superconducting materials with desired properties. This makes it possible, on the one hand, to reduce the mass of the superconductor in finished products, and on the other hand, to provide large magnetic fields with the same mass of the superconducting material.

Example 14

Obtaining the RA modifier $Bi_3TiNbO_9$

1. Preparation of $Bi_3TiNbO_9$ powder

To obtain a modified high-temperature piezoelectric of the $Bi_3TiNbO_9$ (BTN) phase, $Bi_2O_3$ oxides of "chemically pure" grade, corresponding to official standard GOST 10210-75 were used for initial components, together with $TiO_2$ PRETIOX AV1 FG, and $Nb_2O_5$ of grade "2" corresponding to TU 1763-019-00545484-2000 standard. To purify the reagents from the hygroscopic moisture oxides and impurities, such as carbon dioxide and others, adsorbed during storage, the reagents underwent incineration at 400-800°C before weighing.

Mixtures of the composition $3Bi_2O_3 \cdot 2TiO_2 \cdot Nb_2O_5$ were prepared for further synthesis of the pure phase of $Bi_3TiNbO_9$. Then, the mixture was homogenized in distilled water using an Union Process HD/01 attritor. As a result, the size of the component particles decreased to a few micrometers.

The synthesis of the BTN phase powder from the ready mixture was carried out via solid-phase reactions in an SNOL 12/16 furnace, in air. Homogenized mixtures of $Bi_3TiNbO_9$ compositions were baked at 1273 K for 6 hours. Two such baking sessions were carried out with intermediate grinding of the resulting synthesis products.

The procedure yielded polycrystalline samples of $Bi_3TiNbO_9$ of yellow-brown color, uniform to sight. The synthesized material was ground in an attritor and then dried. The resulting powder had a specific surface area $S_{sp}$ of 3500 to 6000 $cm^2$/g.

2. Obtaining modifier from $Bi_3TiNbO_9$ phase powder after baking (p. 1)

The modifier was obtained viay trituration followed by dilution of the resulting trituration in an aqueous or aqueous-alcoholic solution to obtain a release-active form of $Bi_3TiNbO_9$ powder after firing, in the form of a mixture of centesimal dilutions C12C30C50. A dry powder of the $Bi_3TiNbO_9$ phase obtained via firing was used for initial component. Lactose monohydrate was used as neutral carrier in trituration.

To obtain successive triturations C1-C3 (centesimal scale, 1 unit of the parent substance or the previous trituration (C1 or C2) and 99 units of lactose monohydrate is taken), the following procedure is observed. The required amount of lactose monohydrate is divided into 3 equal portions. The first portion of lactose monohydrate is placed in a porcelain mortar and ground to close the pores of the mortar. Then the entire amount of the dry powdered parent substance is added, and the resulting mixture is ground with effort, after which the powder is raked with a spatula and scraped off the walls of the mortar; this operation is repeated once more. Then the second and the third portions of lactose monohydrate are added sequentially, repeating the above actions with each portion. Thus, trituration C1 is obtained. Then, similar to the above process, C2 trituration is obtained (adding 1 unit of C1 trituration to 99 units of lactose) and C3 trituration (adding 1 unit of C2 trituration to 99 units of lactose).

The subsequent dilution C4 is obtained from 1 unit of the trituration of C3 and 99 units (centesimal scale) of 25% aqueous solution of ethyl alcohol. These components are thoroughly mixed until smooth, shaking the closed bottle vertically. C5 dilution is obtained from 1 unit of C4 dilution and 99 parts of 25% aqueous solution of ethyl alcohol, thoroughly mixing the indicated components until smooth, shaking vertically. The required degree of dilution is obtained by repeating the previous steps as appropriate.

Further, to obtain release-active $Bi_3TiNbO_9$ powder after baking, in the form of a mixture of dilutions, according to this example, C12C30C50, centesimal dilutions are prepared according to the above-described technology until dilution which is 3 steps of centesimal dilutions less than the final solution of C12C30C50. For this dilution, C9, C27 and C47, one unit of each dilution (in this example, the volume ratio is 1:1:1) are put into one container containing 97 units of a 70% aqueous solution of ethyl alcohol (for centesimal dilution). The resulting mixture is then sequentially diluted twice in a ratio of 1 to 100, using 70% aqueous solution of ethyl alcohol at the penultimate stage, and 36% aqueous solution of ethyl alcohol at the last stage, thoroughly mixing these components until smooth, shaking the closed bottle with the resulting solution vertically after each dilution. At the last stage, modifier is obtained, a release-active form of $Bi_3TiNbO_9$, by diluting the mentioned parent substance by $100^{12}$, $100^{30}$, $100^{50}$ times, which in terms of homeopathic technology corresponds to a mixture of centesimal dilutions C12, C30 and C50.

Example 15

Obtaining modified $Bi_3TiNbO_9$ piezoceramics using conventional ceramic processing technology

Polycrystalline powders of $Bi_3TiNbO_9$ phase (80 g) obtained according to p.1 of Example 14 were further moistened with modifier (25 ml), a release-active form of a piezoelectric material of the $Bi_3TiNbO_9$ phase obtained after

baking, in the form of a mixture of centesimal dilutions C12C30C50, obtained according to p.1.2 of Example 14. A solution was prepared and the powder was moistened in a laminar flow chamber in a clean environment taking all appropriate measures to prevent the risk of sample contamination. The obtained wetted powders were dried at + 35°C for at least 6 hours until the liquid visibly evaporated.

The resulting modifier-moistened $Bi_3TiNbO_9$ phase powders were molded into cylindrical billets 10 mm in diameter and 1 to 2 mm thick. Before molding, the powders were ground in mortars together with ~1 wt% of 5% aqueous solution of polyvinyl alcohol (PVA) for better homogenization. Molding was performed under single-axis 200 kg/cm$^2$ pressure, using a Shimadzu hydraulic press and a set of appropriate molds.

The billets obtained after molding were sintered in air in a SNOL 12/16 furnace at 1413K for 4 hours.

The procedure yielded ceramic samples in the form of Ø10 × (1-2) mm cylindrical discs. The density of the resulting ceramics measured by dividing the mass of the tablet by its volume, was ~ 80(5)% of the maximum possible density (non-porous ceramics), also called X-ray density.

Example 16

Obtaining modified $Bi_3TiNbO_9$ piezoceramics using hot extrusion

Polycrystalline powders of $Bi_3TiNbO_9$ phase (80 g) obtained according to p.1 of Example 14 were further moistened with modifier (25 ml), a release-active form of a piezoelectric material of the $Bi_3TiNbO_9$ phase obtained after baking, in the form of a mixture of centesimal dilutions C12C30C50, obtained according to p.2 of Example 14. A solution was prepared and the powder was moistened in a laminar flow chamber in a clean environment, taking all appropriate measures to prevent the risk of sample contamination.

The resulting wetted $Bi_3TiNbO_9$ powders were dried at 150°C for 4 hours after which they were sieved through a 700 $\mu$m sieve. Next, press powders were prepared from the powders by introducing 5 mass percent of 5% aqueous PVA solution, thorough mixing and sifting through a sieve.

The resulting press powder was loaded into PG-10 press-form to form briquettes under the pressure of 150 MPa. Cylindrical billets Ø50×10 mm were obtained.

Then the resulting billet was sintered under pressure on a UGP-2 hot pressing unit using an aluminum oxide filling at a temperature of 1423 K and a pressure of 250-300 kg/cm$^2$ for 1 to 4 hours to obtain modified high-temperature piezoceramic phase of $Bi_3TiNbO_9$.

The density of the synthesized ceramic billet measured by the Archimedes method on a high-accuracy balance was 97 to 99% of its X-ray density.

The samples used in further studies were obtained as described above:

1) Samples of $Bi_3TiNbO_9$ phase powder (Example 14, p. 1), treated with RA phase of $Bi_3TiNbO_9$ obtained after baking (Example 14, p.2);
2) Samples of $Bi_3TiNbO_9$ phase powder treated with RA lactose;
3) Samples of $Bi_3TiNbO_9$ phase powder treated with 36.7% aqueous ethanol solution.

Un-treated $Bi_3TiNbO_9$ powder was used for control samples in the research.

For the electrophysical measurements described in Examples 17 and 18, plates were cut out from the cylindrical billets obtained after hot pressing perpendicular to the basal planes (or, similarly, parallel to the direction of the pressure). The size of the resulting plates was 0.5 × 5 × 5 mm. After cutting, they were washed in an ultrasonic bath in distilled water and dried at a temperature of 673 K. On the BTN plates, circular conductive electrodes Ø2.5 mm in diameter were imposed by burning on Ag/Pd conductive paste (70/30%) at 1023 to 1223K.

Example 17

Results of X-ray phase analysis of all obtained samples

$Bi_3TiNbO_9$ samples after their hot pressing synthesis were subject to X-ray phase analysis (XPA), on an automated X-ray diffractometer DRON-4 using filtered copper radiation and Ge crystal powder as an internal standard (Fig. 4). Repeated measurements of the diffraction patterns showed that the positions of the corresponding Bragg reflection angles 2□ coincide, with an accuracy of ± (0.01-0.02).

Diffraction patterns of the samples, by their positions and reflection intensities, correspond to the literature data on the $Bi_3TiNbO_9$ phase [Powder Diffraction files of the International Centre for Diffraction Data (ICDD) (1999)]. All reflections of diffraction patterns of the sintered samples refer to $Bi_3TiNbO_9$ phase with a layered perovskite-like structure, with no significant impurity reflections observed. In this regard, it can be concluded that the synthesized samples are practically single-phase, they consist of a double-layered (n=2) Aurrivillius phase of $Bi_3TiNbO_9$.

The parameters of the rhombic unit cell of the phase obtained during the indication correspond to the literature data on this phase. The manifestation of intense reflections from the (001) planes from the cuts perpendicular to the hot pressing axis, and a significant weakening (or absence) of these reflections on the cuts perpendicular to them indicates that the hot pressed samples are planar textures in which the (001) planes of crystallites are oriented parallel the basal planes of the tablets (perpendicular to the pressure direction during hot pressing).

Example 18

Results of measurements of the $d_{33}$ piezoelectric coefficient

Sample polarization

Polarization was performed in a compressed air installation by applying a 10 kV/mm electric field to the samples at a temperature of 200°C, for 15 to 30 minutes, and cooling to 50-60°C under the field. This mode turned out to be optimal for polarization of $Bi_3TiNbO_9$ ceramics.

Measurement of d33 piezoelectric modulus

The d33 piezoelectric module was measured by the method of oscillating mechanical load on a d33 meter YE2730A (APC, USA) at a frequency of 110 Hz, under room temperature, on pre-polarized ceramic samples.

The results of the measurements are presented in Table 6. In addition, each value given in the table is an average of 10 measurements performed on the same sample.

Table 6: Values of $d_{33}$ piezoelectric coefficient for sections 1 of hot-pressed $Bi_3TiNbO_9$ samples of different series (n)

| | Series 1 | Series 2 | Series 3 | Series 4 |
|---|---|---|---|---|
| | Un-treated (un-modified) $Bi_3TiNbO_9$ powder | $Bi_3TiNbO_9$ powder treated with 36.7% ethanol | $Bi_3TiNbO_9$ powder treated with RA $Bi_3TiNbO^9$ (C12C30C50) | $Bi_3TiNbO_9$ powder treated with RA lactose (C12C30C50) |
| d33 piezoelectric coefficient, pC/N ($\pm$ value of the last character) | 10.1($\pm$0.2) | 10.6($\pm$0.4) | 12.7($\pm$1.1) | 10.7($\pm$0.2) |

It is worth pointing out that the average $d_{33}$ values of the samples of series 3 (12.7 pC/N) are 25% higher than the average $d_{33}$ values of the unmodified samples.

Thus, the use of the declared modifier leads to an increase in one of the main parameters characterizing the piezoelectric activity of the sample under analysis.

Conclusion:

An increase in the piezoelectric coefficient of a substance can significantly improve all the main characteristics of a piezoelectric transducer based on it, that is, to reduce the mass and, accordingly, the response delay of the transducer, and to increase its sensitivity and dynamic range. This is especially important in the case of high-temperature piezo-lectrics like $Bi_3TiNbO_9$ used to manufacture sensors for monitoring the parameters of propulsion systems.

Example 19

Measurement of pyroelectric coefficient

Pyroelectric coefficient $p^{(X)} = (\partial P_s/\partial T)_X$ (where $P_s$ is spontaneous polarization and X is mechanical tension) was determined by the quasi-static method, basing on the results of the temperature dependence measurements of pyroelectric current $I_p$ induced by alterations of sample temperature dT/dt:

$$I_p = dq/dt = d(S\sigma)/dt = SdP_s/dt = S(dP_s/dT)/(dT/dt) = Sp^{(X)}/(dT/dt),$$

where:

q is pyroelectric charge arising on the electrodes upon variation of the temperature of the sample, and □ is the surface density of this charge, equal to $P_s$.

Pyroelectric currents were measured with a V7-30 electrometer; the temperature variation rate was set equal to 0.3 K/s with a "temperature meter regulating the ITR 2523" (OOO NPP Dana-Term, Russia).

For measurements, we used personal Pentium-based computers, a modular data acquisition system of LTR type by L-CARD Company, under the control of the LabView software package.

The findings are presented in Table 7. Each value given in the table is the average of 10 measurements of the same sample.

Table 7: Values of the pyroelectric coefficient $p^{\sigma}$ of different series of BTN samples

| | Un-treated (un-modified) $Bi_3TiNbO_9$ powder | $Bi_3TiNbO_9$ powder treated with RA $Bi_3TiNbO^9$ (C12C30C50) |
|---|---|---|
| Pyroelectric coefficient $p^{\sigma}$ pC/ $(cm^2 \cdot K)$ ($\pm$value of the last character) | 0.75($\pm$3) | 0.96($\pm$6) |
| $Bi_3TiNbO_9$ modified according to the present invention demonstrates a 28% change in pyroelectric coefficient in comparison with the unmodified sample. | | |

Conclusion:

An increase in the pyroelectric coefficient enables nearly proportional increase of the output signal (electrical voltage), without changing the design of the pyroreceiver, or proportional reduction of the pyroreceiver area at a given level of the output signal. In the first case, there is increase in the transducer sensitivity, and in the second case, there is decrease in its dimensions and mass.

According to the findings, modified ceramics has certain promising potential for high-temperature applications, in particular, as electro-acoustic transducers and sensors to be used under high temperatures. The application of the claimed invention, therefore, makes it possible to expand the field of application of ceramics. Its relative ease of implementation makes it attractive for use in various fields of science and technology.

**Claims**

1. A modifier that alters the electrical and magnetic properties of ceramics, , which presents a technology-processed product of one or several components of the batch mix of the specified ceramic sample, the relevant ceramic sample, an intermediate product obtained after baking of the relevant ceramic sample, a known alloying agent, or a combination thereof.

2. Modifier of claim 1, wherein the technology-processed product is an aqueous or aqueous-alcoholic solution obtained by resulting from multiple serial dilutions of the stock substance of the parent substance in combination with external mechanical action - repeated shaking of each dilution, where the parent substance is selected from one or several components of the batch mix used to make ceramics, a relevant ceramic sample, an intermediate product obtained after the baking during the production of the specified ceramic sample, or a known alloying agent.

3. Modifier of claim 1, wherein the batch mix components are the components used for the making of a relevant ceramic sample, including alloying agents.

4. Modifier of claim 1, wherein the ceramic sample is a high-temperature superconductor (HTSC), or piezoelectric material.

5. Modifier of claim 4, wherein the batch mix components used to obtain superconducting ceramics (HTSC) can be chosen from powdered oxides, carbonates, peroxides, hydroxides and salts of the components used to produce ceramics under conventional technology.

6. Modifier of claim 5, wherein the the superconducting ceramics is $YBa_2Cu_3O_7$.

7. Modifier of claim 4, wherein the batch mix components used to obtain piezoelectric ceramics can be chosen from oxides of titanium, zirconium and lead, bismuth titanate, or barium titanate.

8. Modifier of claim 7 wherein the piezoelectric matter is $Bi_3TiNbO_9$.

9. Modifier of claims 3,4, wherein the alloying agents used for the production of superconducting ceramics are Ag and $AgNO_3$.

10. Modifier of claims 3,4, wherein the chosen for alloying agents used for the production of piezoelectric ceramics are $Fe_2O_3$ and $Cr_2O_3$.

11. A method of alteration of the electric and magnetic properties of ceramics, according to which:

   a) The dry mixture of the parent components of the batch mix of the relevant ceramics is homogenized;
   b) The dry mixture is saturated with modifier of claim 1;
   c) The modifier saturated mixture is baked;
   d) Plasticizer is added, and the final modified ceramic sample is molded;
   e) The modifier saturated mixture is sintered according to the relevant ceramic sample production technology.

12. Method of claim 11, which also includes a modifier admixture stage of claim 1 after baking but before sintering.

13. Method of claim 11, wherein the plasticizer is organic polymer, chosen from polyvinyl alcohol, castor oil, wood resin, paraffin, wax, or sulfite alcohol stillage.

14. A method of alteration of the electric and magnetic properties of ceramics, according to which:

   a) The dry mixture of the parent components of the batch mix of the relevant ceramics is homogenized;
   b) The dry mixture is baked;
   c) The dry mixture is saturated with modifier of claim 1;
   d) Plasticizer is added and the resulting modified ceramic sample is molded;
   e) The modifier saturated mix is sintered according to the relevant ceramic sample production technology.

15. Method of claim 14, wherein the plasticizer is organic polymer, chosen from polyvinyl alcohol, castor oil, wood resin, paraffin, wax, or sulfite alcohol stillage.

Fig. 1, a.

Fig. 1, b

Fig. 2.

Fig. 3.

Fig. 4.

## INTERNATIONAL SEARCH REPORT

| | International application No. |
|---|---|
| | PCT/RU 2022/050141 |

**A. CLASSIFICATION OF SUBJECT MATTER**

C04B 35/626 (2006.01); C04B 35/634 (2006.01); C04B 35/45 (2006.01); C04B 35/462 (2006.01); C04B 35/49 (2006.01)

According to International Patent Classification (IPC) or to both national classification and IPC

**B. FIELDS SEARCHED**

Minimum documentation searched (classification system followed by classification symbols)

C04B 35/626-35/636, 35/45, 35/46-35/462, 35/48, 35/49, 111/94

Documentation searched other than minimum documentation to the extent that such documents are included in the fields searched

Electronic data base consulted during the international search (name of data base and, where practicable, search terms used)

PatSearch (RUPTO internal), USPTO, PAJ, Esp@cenet, DWPI, EAPATIS, PATENTSCOPE

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | RU 2455262 C2 (GOU VPO «SANKT-PETERBURGSKY GOSUDARSTVENNY TEKHNOLOGICHESKY INSTITUT (TEKHNICHESKY UNIVERSITET) 10.07.2012, the claims, examples 1, 2 | 1<br>3-5,11,13-15<br>2,6-10,12 |
| Y | RU 2614322 C1 (FEDERALNOE GOSUDARSTVENNOE BIUDZHETNOE UCHREZHDENIE NAEKI «INSTITUT KHIMII SILIKATOV IM.I.V. GREBENSCHIKOVA RAN) 24.03.2017, the abstract p.5, lines 5-17 | 3 |
| Y | RU 2021226 C1 (KRASNOIARSKY GOSUDARSTVENNY UNIVERSITET) 15.10.1994, p.3, lines 26-37, examples 1, 2 on p.4 | 4-5, 11, 13-15 |
| Y | RU 2713835 C1 (LUGOVAIA MARIIA ANDREEVNA et al.) 07.02.2020, the claims | 11, 13-15 |
| A | US 6268054 B1 (CABOT CORP) 31.07.2001 | 1-15 |

☐ Further documents are listed in the continuation of Box C.　　☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 29 July 2022 (29.07.2022) | 25 August 2022 (25.08.2022) |

| Name and mailing address of the ISA/ RU | Authorized officer |
|---|---|
| | |
| Facsimile No. | Telephone No. |

Form PCT/ISA/210 (second sheet) (July 1998)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- RU 2062308 C1, Bush A.A.
- RU 2351677 C2, Donchak A.A.
- RU 2018499 C1, Popov G.P.
- RU 2713835 C1, Lugavaya M.A.
- RU 2498958 C1
- RU 2183325
- RU 2565401
- RU 2579262
- RU 2643934
- RU 2643936
- WO 2012017324 A
- US 7229648 B
- US 4311897 A
- US 4311889 A

### Non-patent literature cited in the description

- **BARASH YU.S.** HIGH-TEMPERATURE SUPER-CONDUCTORS. *The Great Russian Encyclopedia,* 2006, vol. 6, 140-141
- **SALAKHOV A.M.** Modern materials. Ministry for Education and Science of the Russian Federation, KFU. Kazan: Kazan Federal University, 2016, 349
- **SPITSIN A.I. ; BUSH A. A. ; KAMENTSEV K.E.** Piezoelectric and dielectric properties of Bi3TiNbO9 prepared by hot pressing from powders activated using the serial dilution method. *Sci Rep,* 2020, vol. 10, 22198
- **ZHANG Z ; YAN H ; DONG X ; WANG Y.** Preparation and electrical properties of bismuth layer-structured ceramic Bi3TiNbO9 solid solution. *Materials Research Bulletin,* 2003, vol. 38 (2), 241-248
- **NESTEROV A.A. ; PANICH A.A.** *Actual problems of materials science of ceramic piezomaterials,* 2010
- **ZHITNYUK S.V.** *The influence of sintering additives on the properties of ceramics based on silicon carbide,* 2019
- **MARKOV L.K.** Influence of silver content on mechanical and electrical properties of HTSC ceramics YBaCuO/Ag. *Solid State Physics,* 2003
- **PAULA DE AXAMBUJA.** *Conductivity Fluctuations of Polycrystalline Ag-Doped YBa2Cu3O7-δ Superconductor,* 2010
- **VINTAYKIN B.E.** Solid state physics. Publishing house of the Bauman Technical University, 2006
- **O.I. EPSTEIN.** Ultra-low doses (A history of one study). RAMS Publishing House, 2008, 336
- **EPSTEIN O.** The spatial homeostasis hypothesis. *Symmetry,* 2018, vol. 10 (4
- **SCHWABE V.** *Homeopathic Medicines, Moscow,* 1967
- **EPSHTEIN O.I.** Release-activity (a modern view of homeopathy and non-homeopathy). Publishing house of the Russian Academy of Medical Sciences, 2017